# EUROPEAN PATENT APPLICATION

(11) **EP 1 152 044 A1**
(43) Date of publication of application: **07.11.2001**
(21) Application number: 99954376.2
(22) Date of filing: 04.11.1999
(51) Int. Cl.: C09D 183/02, C09J 183/02, G02F 1/136, H01L 21/316

(54) **SOLUTION FOR FORMING SILICA COATING FILM, PROCESS FOR PRODUCING THE SAME, AND SILICA COATING FILM AND PROCESS FOR PRODUCING THE SAME**

(30) Priority: 04.11.1998 JP 31375498
(71) Applicant: MATSUSHITA ELECTRIC INDUSTRIAL CO., LTD., Kadoma-shi, Osaka 571-8501 (JP)
(72) Inventor: OGAWA, Kazufumi, Nara-shi, Nara 630-8101 (JP); TAKEBE, Takako, Katano-shi, Osaka 576-0054 (JP); OTAKE, Tadashi, Neyagawa-shi, Osaka 572-0816 (JP); NOMURA, Takaiki, Osaka-shi, Osaka 546-0003 (JP)
(74) Representative: Dempster, Benjamin John Naftel
(86) International application number: JP9906143
(87) International publication number: WO0026311

(57) **Abstract**

The present invention provides a solution for forming a silica-based coating film which, by comprising an organic solvent and a chlorosiloxane compound, is excellent in terms of reactivity with a substrate material. When this solution for forming a silica-based coating film is applied to a surface of a substrate material in a dry atmosphere and the substrate material is put into an atmosphere containing moisture, a silica-based coating film excellent in terms of durability can be manufactured without adding a catalyst or carrying out heat treatment. In addition, by adding anhydrous silica fine particles to the solution for forming a silica-based coating film, a solution that enables the controlling of viscosity and is excellent in terms of film coatability can be prepared. When this solution for forming a silica-based coating film is applied to a surface of a substrate material in a dry atmosphere and the substrate material is put into an atmosphere containing moisture, a thick silica-based coating film can be prepared without adding a catalyst or carrying out heat treatment.

## Description

### TECHNICAL FIELD

The present invention relates to a solution for forming a silica-based coating film that can be suitably used for an insulating film, planarizing film, protective film or the like, of a device such as a semiconductor device or a liquid crystal display device and a manufacturing method thereof, as well as a silica-based coating film prepared by using the solution and a manufacturing method thereof.

### BACKGROUND ART

Conventionally, in order to improve the hardness of a surface of a flexible substrate material such as plastic, a hard coat film is formed on a surface of the substrate material. An example of such a hard coat film is a silica coating film formed by, for example, a sol-gel method.

In forming a silica coating film by the above-mentioned sol-gel method, first an acid catalyst is added to an alcohol solution in which an alkoxysilane compound such as tetraethoxysilane has been dissolved. With the addition of the acid catalyst, the above-mentioned alkoxysilane compound undergoes dealchoholization, and thus a solution for forming a silica coating film is prepared. Next, this solution is applied to a substrate material, and the substrate material is subjected to such steps as heat treatment at a prescribed temperature to form a silica coating film. In this method, an acid catalyst is added in an effort to increase the necessary calcination temperature.

However, the above-described conventional manufacturing method of a silica coating film has the following problems.

First, the conventional solution for forming a silica coating film has a drawback such that when an acid catalyst is added to the solution beforehand, the catalytic activity of the acid catalyst decreases and the pot life of the solution is reduced. For these reasons, having to carry out such steps as adding an acid catalyst immediately before using the above-described solution for forming a silica coating film complicates the manufacturing process.

In addition, in the above-described conventional manufacturing method, the calcination temperature is raised by the addition of a catalyst, but because the calcination temperature is in a high temperature region, substrate materials comprising plastic, for example, cannot be used. In other words, the conventional manufacturing method limits the substrate material that can be used. Furthermore, it is necessary to adjust the conditions of the heat treatment depending on the materials used for the substrate material. Moreover, in order to carry out the heat treatment process, heating equipment is of course necessary, thus bringing about an increase in manufacturing costs. In addition to these various problems, the heat treatment process itself is not energy saving.

Still more, because the viscosity of the solution for forming a silica coating film is low, film coatability worsens, and as a result, it is difficult to form a thick silica coating film.

The present invention has been realized in view of the above-described problems in prior art. It is an object of the present invention to provide a solution for forming a silica coating film which eliminates the need for an addition of a catalyst and a heat treatment process and which enables formation, at room temperature, of a thick silica coating film that has excellent film formability and a manufacturing method thereof, as well as a silica coating film and a manufacturing method thereof.

### DISCLOSURE OF THE INVENTION

The present inventers thoroughly investigated solutions for forming a silica-based coating film and methods of manufacturing thereof in order to solve the above-described problems in prior art. As a result, the inventers discovered that a solution for forming a silica-based coating film, the solution comprising an organic solvent and a chlorosiloxane compound, is excellent in terms of reactivity with a substrate material and thus achieved the present invention.

In addition, in order to solve the above-described problems in prior art, the present inventers thoroughly investigated silica-based coating films formed utilizing the above-mentioned solutions for forming a silica-based coating film and methods of manufacturing thereof. As a result, the inventers discovered that a silica-based coating film, the coating film being formed on a surface of a substrate material by siloxane bonds, forming siloxane bonds with the above-mentioned substrate material through dehydrochlorination, and having a chemical structure that does not contain hydrocarbon groups, is excellent in terms of abrasion resistance and scratch resistance and that such a film can be produced without a heat treatment step and thus achieved the present invention.

In order to solve the above-described problems, a solution for forming a silica-based coating film of the present invention has the constitution described below.

(1) A solution for forming a silica-based coating film according to a first aspect of the present invention, comprises:
an organic solvent; and
a siloxane compound having activating groups.

In the above-mentioned constitution, because a large number of activating groups exist in the siloxane compound, it is possible to chemically adsorb the siloxane compound to a substrate material on a surface of which functional groups having active hydrogens exist, by dehydrochlorination between the activating groups and the functional groups having active hydrogens. Thereby, according to the above-described constitution, a solution for forming a silica-based coating film that is excellent in terms of reactivity with a substrate material in comparison to prior art solutions for forming a silica-based coating film, which are manufactured by methods such as the sol-gel method, can be provided. It is to be noted that the term, "activating groups," denotes functional groups that exhibit reactivity with functional groups having active hydrogens. In addition, functional groups having active hydrogens denote, for example, hydroxyl groups (-OH) or imino groups (>NH).

An example of the siloxane compound having activating groups is a compound represented by the general formula (I): 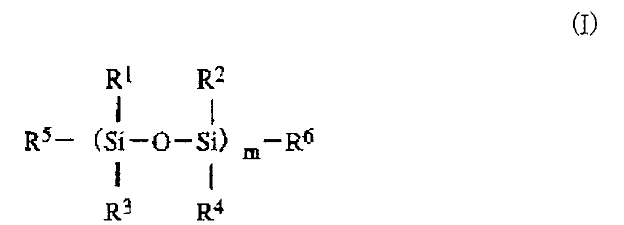 wherein R¹ to R⁴, independently of one another, are a hydrogen atom, a halogen, an isocyanate group, a hydroxyl group, a chlorosilyl group, a dichlorosilyl group, a trichlorosilyl group, a silanol group, or a silicon-containing functional group in which cross-linking can be obtained by forming siloxane bonds; R⁵ and R⁶, independently of one another, are a hydrogen atom, a halogen, an isocyanate group, or a hydroxyl group; and m is an integer of 1 or greater.

The siloxane compound having activating groups may be a chlorosiloxane.

The chlorosiloxane may be a chlorosiloxane oligomer.

The chlorosiloxane oligomer may be at least one compound selected from the group consisting of the compounds represented by the general formula (II), the general formula (III), and the general formula (IV): 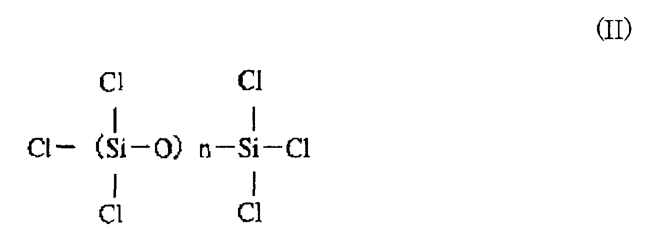 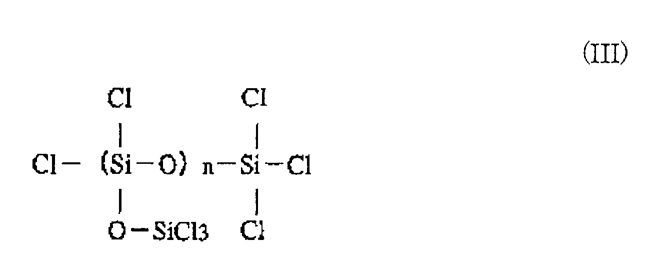 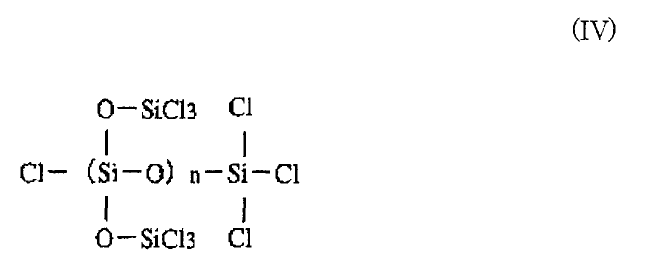 wherein n is an integer of 1 or greater.

The organic solvent may be a nonaqueous organic solvent. The term, "nonaqueous organic solvent," denotes an organic solvent which does not contain substances having active hydrogens, including impurities such as water, and which does not react with a silane compound having activating groups.

The nonaqueous organic solvent may be at least one organic solvent selected from the group consisting of a hydrocarbon-based organic solvent, a fluorine-based organic solvent, and a chlorine-based organic solvent.

In the above-mentioned constitution, by using a solvent containing one, or two or more organic solvents selected from the group consisting of a hydrocarbon-based organic solvent, a fluorine-based organic solvent, and a chlorine-based organic solvent, all of which absorb little moisture, it is possible to prevent dehydrochlorination between activating groups in the siloxane compound and the above-mentioned moisture, and to provide a solution for forming a silica-based coating film that is excellent in terms of reactivity with a substrate material as is mentioned above.

The solution for forming a silica-based coating film may further comprise an alkoxysilane compound.

The alkoxysilane compound may be at least one compound selected from the group consisting of tetraethoxysilane and propyloxysilane.

A method of manufacturing a solution for forming a silica-based coating film of the present invention, corresponding to the first aspect, comprises the steps of:
dissolving a silane compound having activating groups in a first organic solvent in a dry atmosphere whereby a first mixed solution is prepared;
mixing an oligomerizer, for oligomerizing the silane compound having activating groups, in a second organic solvent whereby a second mixed solution is prepared; and
mixing the first mixed solution and the second mixed solution in a dry atmosphere.

In the above-described method, when the first mixed solution is formed, because the silane compound having activating groups is dissolved in a dry atmosphere, dehydrochlorination between activating groups in the silane compound and moisture in the atmosphere is prevented, and degradation in the reactivity of the silane compound having activating groups is prevented. In addition, because the first mixed solution and the second mixed solution are mixed in a dry atmosphere, the silane compound having activating groups reacts with the oligomerizer contained in the second mixed solution. Thus, because dehydrochlorination between the above-mentioned silane compound and excess moisture contained in the atmosphere is not brought about, a siloxane compound containing many activating groups is compounded. As a result, it is possible to manufacture a solution for forming a silica-based coating film which is excellent in terms of reactivity with a substrate material on which functional groups having activating groups exist.

The above-mentioned oligomerizer denotes a substance which, by reacting with the silane compound having activating groups that is dissolved in the first mixed solution, compounds a siloxane compound having a degree of polymerization approximately equal to that of an oligomer and having activating groups.

It is preferable that the mole ratio of the oligomerizer to the silane compound having activating groups be equimolar or less.

The oligomerizer may be water.

The silane compound having activating groups may be at least one compound selected from the group consisting of tetrachlorosilane, trichlorosilane, dichlorosilane, hexachlorodisiloxane, and octachlorotrisiloxane.

Each of the first organic solvent and the second organic solvent may comprise at least one organic solvent selected from the group consisting of a hydrocarbon-based organic solvent, a fluorine-based organic solvent, and a chlorine-based organic solvent.

A silica-based coating film of the present invention corresponding to the first aspect, is comprised such that:
the silica-based coating film is formed on a surface of a substrate material by siloxane bonds; and
the chemical structure of the silica-based coating film does not contain hydrocarbon groups.

In the above-described constitution, the silica-based coating film is formed by siloxane bonds with the surface of the substrate material and is excellent in terms of adhesion with the substrate material. In addition, while silica-based coating films comprising molecules having branched chains such as hydrocarbon groups (specifically, methyl groups and the like) are formed in prior art methods, for example in the sol-gel method which utilizes an alkoxysilane compound, the silica-based coating film according to the present invention does not contain impurities such as hydrocarbon groups in its chemical structure. Thus, the film is very high-grade and excellent in terms of hardness and transparency.

The silica-based coating film may comprise a repeating unit represented by the structural formula (V): 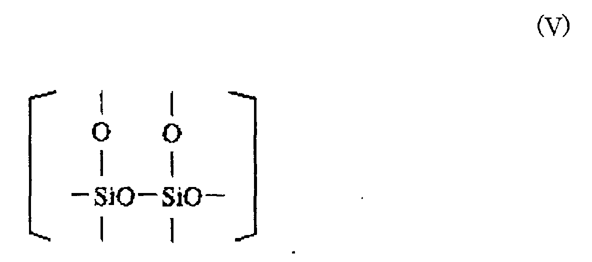 Thereby, the silica-based coating film can have a network structure and be excellent in terms of abrasion resistance and scratch resistance.

The substrate material may have functional groups having active hydrogens on its surface and may have a heat resistance of 150°C or less. The phrase, "a heat resistance of 150°C or less," denotes that in a temperature range of 150°C or less changes in the physical shape or chemical properties of the substrate material accompanying heat treatment are not observed.

A method of manufacturing a silica-based coating film corresponding to the first aspect, comprises the steps of:
an applying step of applying the solution for forming a silica-based coating film to a surface of a substrate material in a dry atmosphere;
a drying step of evaporating the organic solvent whereby a siloxane compound coating film having activating groups is formed; and
a silica-based coating film forming step of putting the siloxane compound coating layer in contact with molecules of water whereby a silica-based coating film is formed on the surface of the substrate material.

In the above-described method, by applying the solution for forming a silica-based coating film to the surface of the substrate material, activating groups in the siloxane compound react with functional groups having active hydrogens that exist on the surface of the substrate material, causing chemical adsorption of the siloxane compound. Thereby, a siloxane compound coating film having activating groups can be formed on the surface of the substrate material. Next, by reacting the siloxane compound coating film with water molecules, activating groups in the siloxane compound and hydroxyl groups in the water molecules react and a silica-based coating film can be formed. Thus, a silica-based coating film can be very easily formed without carrying out the steps of adding a catalyst and heat treatment as are carried out in the prior art sol-gel method.

The silica-based coating film forming step may be carried out in an atmosphere containing moisture.

The method of manufacturing a silica-based coating film may further comprise a heat treatment step of heating the silica-based coating film at a temperature of 100°C or higher after the silica-based coating film forming step.

(2) A solution for forming silica-based coating film according to a second aspect of the present invention comprises:
a nonaqueous organic solvent; and
a compound wherein a silane compound having activating groups is bonded to anhydrous silica fine particles.

In the above-described constitution, by including anhydrous silica fine particles in the solution for forming a silica-based coating film, the viscosity of the solution can be improved and an improvement in film coatability can be expected. In addition, the above-mentioned silane compound having activating groups and the anhydrous silica fine particles are bonded by siloxane bonds (-SiO-). This is because of the reaction between functional groups having active hydrogens which exist on the surfaces of the anhydrous silica fine particles and activating groups.

Furthermore, because a large number of activating groups exist in the compound in which anhydrous silica fine particles are bonded to the above-mentioned silane compound, it is possible to chemically adsorb the silane compound to a substrate material on a surface of which functional groups having active hydrogens exist, by dehydrochlorination between the activating groups and the functional groups having active hydrogens. Thereby, according to the above-described constitution, a solution for forming a silica-based coating film that is excellent in terms of reactivity with a substrate material in comparison to prior art solutions for forming a silica-based coating film which are manufactured by methods such as the sol-gel method, can be provided.

The term, "anhydrous silica fine particles," denotes silica fine particles from the surface of which water has been removed and on the surface of which functional groups having active hydrogens exist. The term, "nonaqueous organic solvent," denotes an organic solvent which does not contain substances having active hydrogens, including impurities such as water, and does not react with the silane compound having activating groups. The term, "activating groups," denotes functional groups that exhibit reactivity with functional groups having active hydrogens. In addition, functional groups having active hydrogens denote, for example, hydroxyl groups (-OH) or imino groups (>NH).

The solution for forming a silica-based coating film may comprise titanium oxide fine particles in place of the anhydrous silica fine particles.

An example of the silane compound having activating groups is a compound represented by the general formula (VI): 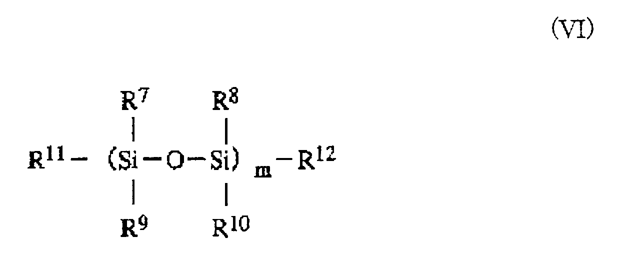 wherein R⁷ to R¹⁰, independently of one another, are a hydrogen atom, a halogen, an isocyanate group, a hydroxyl group, a functional group containing a chlorosilyl group, a functional group containing a dichlorosilyl group, a functional group containing a trichlorosilyl group, a functional group containing a silanol group, or a silicon-containing functional group in which cross-linking can be obtained by forming siloxane bonds; R₁₁ and R₁₂, independently of one another, are a hydrogen atom, a halogen, an isocyanate group, or a hydroxyl group; and m is an integer of 1 or greater.

The silane compound having activating groups may be a chlorosilane compound.

The compound represented by the general formula (VI) may be at least one compound selected from the group consisting of compounds represented by the general formula (VII), the general formula (VIII), and the general formula (IX): 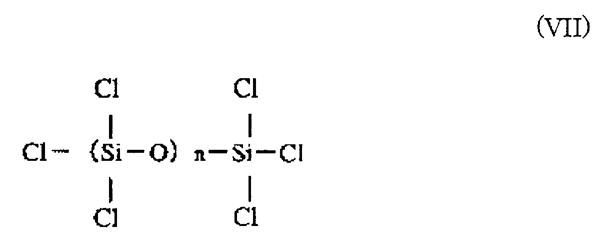 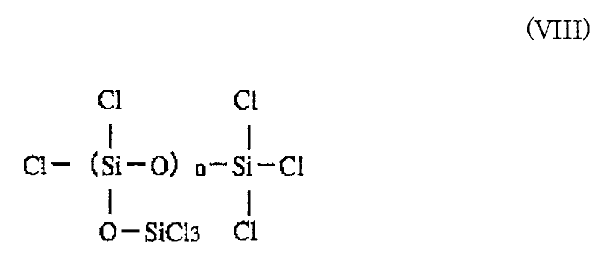 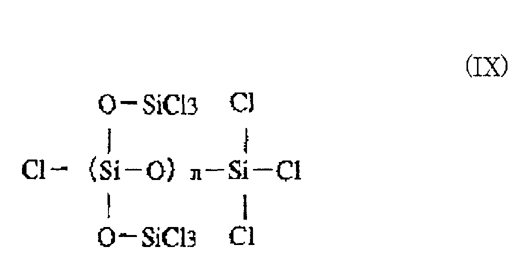 wherein n is an integer of 1 or greater.

The nonaqueous organic solvent may be at least one organic solvent selected from the group consisting of a hydrocarbon-based organic solvent, a fluorine-based organic solvent, and a chlorine-based organic solvent.

The solution for forming a silica-based coating film may further comprise an alkoxysilane compound.

The alkoxysilane compound may be at least one compound selected from the group consisting of tetraethoxysilane and propyloxysilane.

A method of manufacturing a solution for forming a silica-based coating film corresponding to the second aspect, comprises the steps of:
dissolving a silane compound having activating groups in a first nonaqueous organic solvent in a dry atmosphere whereby the third mixed solution is prepared;
mixing water in a second nonaqueous organic solvent whereby the fourth mixed solution is prepared; and
mixing the third mixed solution and the fourth mixed solution in a dry atmosphere so that the silane compound having activating groups reacts with the water;
the method of manufacturing wherein anhydrous silica fine particles are dispersed in at least one of the third mixed solution and the fourth mixed solution.

In the above-described method, when the third mixed solution is prepared, because the silane compound having activating groups is dissolved in a dry atmosphere, reaction between the activating groups in the silane compound is prevented, and degradation in the reactivity of the silane compound is prevented.

In addition, because the third mixed solution and the fourth mixed solution are mixed in a dry atmosphere, the silane compound having activating groups reacts only with the water contained in the fourth mixed solution. Furthermore, because the anhydrous silica fine particles are dispersed in at least one of the third mixed solution and the fourth mixed solution, the activating groups in the silane compound react with the functional groups having activating groups which exist on the surface of the anhydrous silica fine particles. Thereby, a compound in which the silane compound having activating groups is bonded to the anhydrous silica fine particles by siloxane bonds is compounded. In other words, it is possible to manufacture a solution for forming a silica-based coating film in which a compound, such as one in which a silane compound having activating groups is bonded to anhydrous silica fine particles, is dispersed. Moreover, the solution for forming a silica coating film prepared in the above-described manner is such that by varying the amount of anhydrous silica fine particles added as needed, the viscosity can be controlled, and film coatability is excellent. Still more, because the above-described compound, in which the silane compound is bonded to the anhydrous silica fine particles, contains many activating groups, it is possible to manufacture a solution for forming a silica-based coating film which is excellent in terms of reactivity with a substrate material on which functional groups having activating groups exist.

In the method of manufacturing a solution for forming a silica-based coating film, titanium oxide fine particles may be used in place of anhydrous silica fine particles.

It is preferable that the mole ratio of the water to the silane compound having activating groups be equimolar or less.

The silane compound having activating groups may be a chlorosilane compound.

The chlorosilane compound may be at least one compound selected from the group consisting of tetrachlorosilane, trichlorosilane, dichlorosilane, hexachlorodisiloxane, and octachlorotrisiloxane.

Each of the first nonaqueous organic solvent and the second nonaqueous organic solvent may comprise at least one organic solvent selected from the group consisting of a hydrocarbon-based organic solvent, a fluorine-based organic solvent, and a chlorine-based organic solvent.

A silica-based coating film of the present invention corresponding to the second aspect, is comprised such that:
the silica-based coating film is formed on a surface of a substrate material by siloxane bonds;
the silica-based coating film contains anhydrous silica fine particles, the anhydrous silica fine particles being bonded to the silica-based coating film and the substrate material by siloxane bonds; and
the chemical structure of the silica-based coating film does not contain hydrocarbon groups.

In the above constitution, because the silica-based coating film is formed by the formation of siloxane bonds with the substrate material and with the anhydrous silica fine particles, adhesion with the substrate material is excellent. In addition, while silica-based coating films comprising molecules having branched chains such as hydrocarbon groups (specifically, methyl groups and the like) were formed in prior art methods, for example in the sol-gel method which utilizes an alkoxysilane compound, the silica-based coating film according to the present invention does not contain impurities such as hydrocarbon groups in its chemical structure. Thus, the film is very high-grade and excellent in terms of hardness and transparency.

The silica-based coating film may comprise titanium oxide fine particles in place of anhydrous silica fine particles.

The silica-based coating film may comprise a repeating unit represented by the structural formula (V): 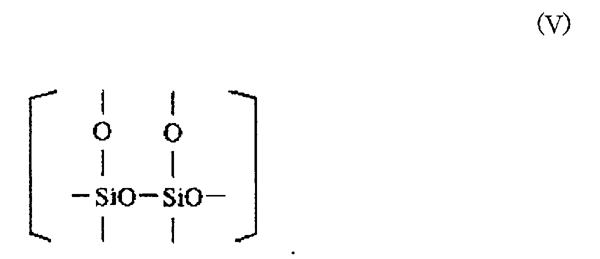 Thereby, the silica-based coating film can be such that it has a network structure and is excellent in terms of abrasion resistance and scratch resistance.

The substrate material may have functional groups having active hydrogens on its surface and may have a heat resistance of 150°C or less. The phrase, "a heat resistance of 150°C or less," denotes that in a temperature range of 150°C or less changes in the physical shape or chemical properties of the substrate material accompanying heat treatment are not observed.

A method of manufacturing a silica-based coating film corresponding to the second aspect, comprises the steps of:
an applying step of applying a solution for forming a silica-based coating film to a surface of a substrate material in a dry atmosphere;
a drying step of evaporating the nonaqueous organic solvent whereby a siloxane compound coating film is formed; and
a silica-based coating film forming step of putting the siloxane compound coating layer in contact with molecules of water whereby a silica-based coating film containing the anhydrous silica fine particles is formed on the surface of the substrate material.

In the above-described method, because the compound, in which the silane compound having activating groups is bonded to the anhydrous silica fine particles, is dispersed in the solution for forming a silica-based coating film, if the viscosity of the solution is controlled by varying the amount of anhydrous silica fine particles added as needed, a thick application without sagging or running is achievable when the solution for forming a silica-based coating film is applied to the surface of the substrate material. Thus, when a thick silica-based coating film is desired, a silica-based coating film can be very easily formed without carrying out the steps of adding a catalyst and heat treatment as were carried out in the sol-gel method from prior art.

The silica-based coating film forming step may be carried out in an atmosphere containing moisture.

A heat treatment step of heating the silica-based coating film at a temperature of 100°C or higher may be carried out after the silica-based coating film forming step.

(3) In other aspects of the present invention, the following examples can be given.

When the above-described solution for forming a silica-based coating film according to the first or second aspects is used as an adhesive composition, this bonding method comprises the steps of:
an applying step of applying the solution for forming a silica-based coating film to a surface of an object in a dry atmosphere;
a securing step of securing the object to another object with the solution for forming a silica-based coating film which was applied to the surface of the object;
a drying step of evaporating the nonaqueous organic solvent whereby a chlorosiloxane oligomer coating film is formed; and
a silica-based coating film forming step wherein by putting the chlorosiloxane oligomer coating film in contact with molecules of water and forming a silica-based coating film on the surface of the substrate material, the object and the other object are bonded.

In the above-described method, because the silica-based coating film chemically adsorbs to the bonding surfaces of the object and the other object, the solution for forming a silica-based coating film can be used as an adhesive composition.

The invention also provides a bonded structure in which the solution for forming a silica-based coating film according to the first or the second aspect of the invention is used as an adhesive and an arbitrary object and another object are bonded therewith, and the bonded structure is such that the object and the other object are bonded with the silica-based coating film disposed therebetween.

Moreover, a silica-based coating film formed by using the solution for forming a silica-based coating film is particularly excellent in terms of transparency, and thus can used particularly as paint (varnish) for forming a glossy, transparent coat.

Furthermore, it can also be used as paint for forming a colored coat by adding any one member of the group consisting of a colorant, a dyestuff, or a pigment to the above-mentioned paint composition.

Still more, a silica-based coating film corresponding to the first and second aspects, may be used as a passivation film for use in a semiconductor device.

On the other hand, a silica-based coating film corresponding to the first and second aspects, may also be used as a passivation film for use in a thin film transistor array.

Further objects, characteristics, and superior aspects of the present invention, can be sufficiently understood from the following description. The advantages of the present invention are made clear by the following explanation with reference to the attached drawings.

### BRIEF DESCRIPTION OF THE DRAWINGS

Fig. 1 is a schematic cross sectional view of a chlorosiloxane oligomer coating film in accordance with Embodiment 1 of the present invention.
Fig. 2 is a schematic cross sectional view of a silica-based coating film in accordance with the above-mentioned Embodiment 1 of the present invention.
Fig. 3 is a schematic cross sectional view of a chlorosiloxane oligomer coating film in accordance with Embodiment 2 of the present invention.
Fig. 4 is a schematic cross sectional view of a silica-based coating film in accordance with the above-mentioned Embodiment 2 of the present invention.

### BEST MODE FOR CARRYING OUT THE INVENTION

### EMBODIMENT 1

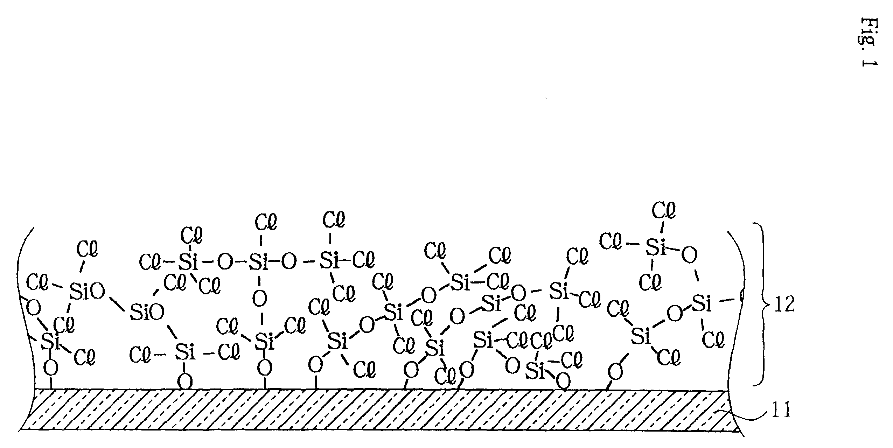

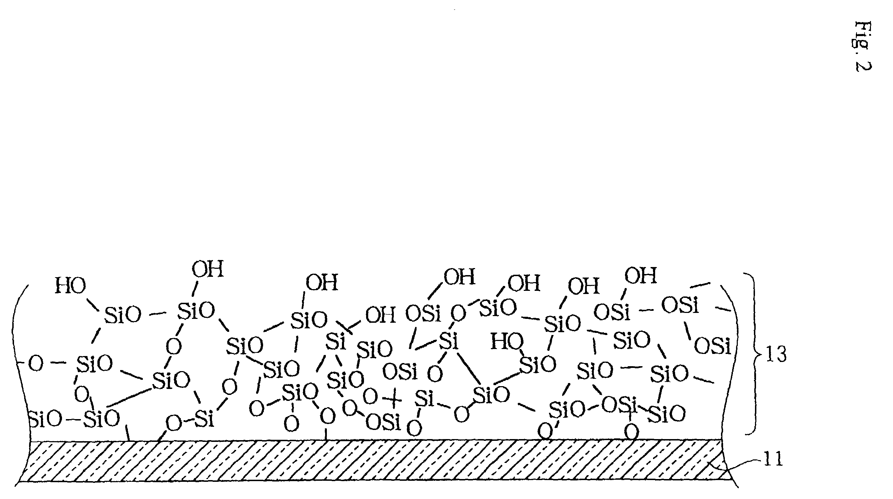

The present Embodiment 1 corresponds to the first aspect of the present invention. Based on Figures 1 and 2, Embodiment 1 is explained as follows. It is to be noted that in the figures unnecessary portions have been omitted and that in order to facilitate the explanation, some portions have been expanded or reduced.

First, a solution for forming a silica-based coating film according to the present Embodiment 1 is described in detail. The above-mentioned solution for forming a silica-based coating film is composed such that it contains at least an organic solvent and a siloxane compound having activating groups.

The above-mentioned siloxane compound having activating groups is composed such that it contains a compound represented by the general formula (I) below: 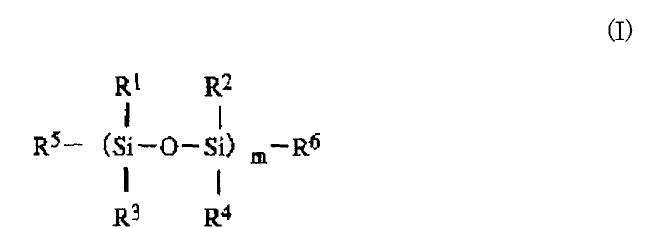 wherein R¹ to R⁴, independently of one another, are a hydrogen atom, a halogen, an isocyanate group, a hydroxyl group, a chlorosilyl group, a dichlorosilyl group, a trichlorosilyl group, a silanol group, or a silicon-containing functional group in which cross-linking can be obtained by forming siloxane bonds; R⁵ and R⁶, independently of one another, are a hydrogen atom, a halogen, an isocyanate group, or a hydroxyl group; and m is an integer of 1 or greater.

The above-described siloxane compound having activating groups is not limited to a chain compound that has a linear structure, branched structure, or the like, and a cyclic compound may be used. In addition, in the compound represented by the general formula (I), m is an integer of 1 or greater, but it is preferable that m be within the range of 2 to 1000, a degree of polymerization approximately equal to that of an oligomer, and it is even more preferable that m be within the range of 4 to 100. When a siloxane compound having a degree of polymerization greater than that of an oligomer, as when m is greater than 1000, is contained in a solution for forming a silica-based coating film, the viscosity of the solution itself increases and the handleability worsens. Thus, it is not preferable that m be greater than 1000.

A specific example of the above-described siloxane compound having activating groups is a chlorosiloxane compound. An example of a chlorosiloxane compound is a chlorosiloxane oligomer.

The above-mentioned chlorosiloxane oligomer, specifically, may contain one, or two or more compounds selected from the group consisting of compounds represented by the general formula (II), the general formula (III), and the general formula (IV) below: 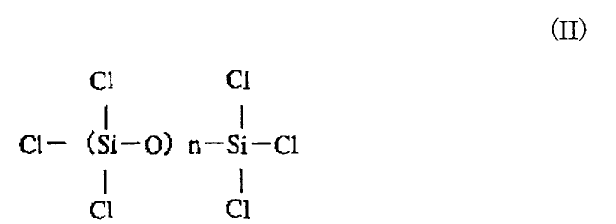 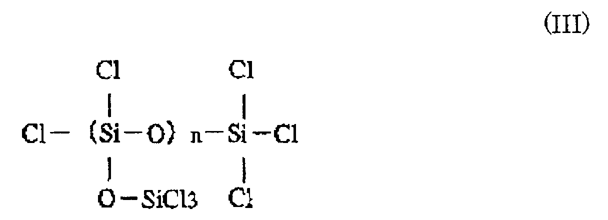 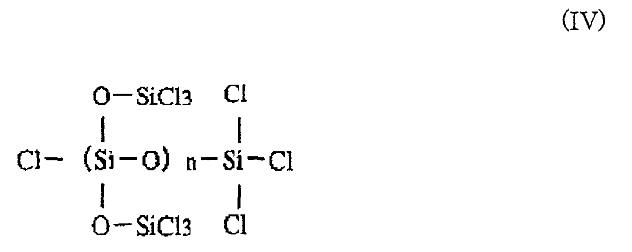 wherein n is an integer of 1 or greater.

It is to be noted that in the case of the above-described chlorosiloxane oligomer represented by the general formulas (II) to (IV), n is an integer of 1 or greater, but it is preferable that n be within the range of 2 to 1000, a degree of polymerization approximately equal to that of an oligomer, and it is even more preferable that n be within the range of 4 to 100.

An example of the above-mentioned organic solvent is a nonaqueous organic solvent. For the above-mentioned nonaqueous organic solvent, solvents containing one, or two or more organic solvents selected from the group of organic solvents consisting of a hydrocarbon-based organic solvent, a fluorine-based organic solvent, and a chlorine-based organic solvent can be used. The above-mentioned hydrocarbon-based organic solvent is not particularly limited, and specific examples include n-hexane, toluene, cyclohexane, isooctane, and dimethyl silicon. In addition, the above-mentioned fluorine-based organic solvent is not particularly limited, and an example is perfluorooctane. The above-mentioned chlorine-based solvent also is not particularly limited, and an example is chloroform. By using these nonaqueous organic solvents, there is the advantage of being able to easily remove water from the nonaqueous organic solvents. Moreover, because among organic solvents, nonaqueous organic solvents absorb little moisture, dehydrochlorination of activating groups in the siloxane compound, for example chlorosilyl groups in a chlorosiloxane oligomer, with excess water is prevented. Thereby, a solution for forming a silica-based coating film which contains many chlorosilyl groups as the activating groups and has a high reactivity can be prepared. In addition, the boiling points of the nonaqueous organic solvents used for the present invention are low in comparison to the boiling points of organic solvents used for prior art solutions for forming a silica-based coating film. For this reason, it is possible to evaporate the nonaqueous organic solvents at room temperature without carrying out heat treatment. Thus, a solution for forming a silica-based coating film which has excellent handleability can be provided.

Next, a manufacturing method of the solution for forming a silica-based coating film according to the present Embodiment 1 will be described in detail. First, solution A (a first mixed solution) is prepared by mixing and dissolving a chlorosilane compound, which functions as a silane compound having activating groups, in a first nonaqueous organic solvent (a first organic solvent). When this solution A is prepared, the preparation is carried out in a dry atmosphere, for example, dry air, dry nitrogen, or dry helium, such that the relative humidity is within the range of 35% or less. When the relative humidity exceeds 35%, the moisture in the atmosphere and the chlorosilyl groups in the chlorosilane compound excessively react, causing the solution to become clouded. Examples for the chlorosilane compound include tetrachlorosilane (SiCl₄), trichlorosilane (SiHCl₃), dichlorosilane (SiH₂Cl₂), hexachlorodisiloxane (SiCl₃-O-SiCl₃), and octachlorotrisiloxane (Cl (SiCl₂O)₂ SiCl₃). It is desirable to use at least one compound selected from this group to obtain a silica-based coating film that does not contain impurities such as hydrocarbon groups. It is to be noted that it is preferable that the concentration of the chlorosilane compound dissolved in the first nonaqueous organic solvent be within the range of 0.01 M/L to 10 M/L. When the concentration is less than 0.01 M/L, the effect of forming the silica-based coating film is small. On the other hand, when the concentration is greater than 10 M/L, it is difficult, when the solution for forming a silica-based coating film is used, to carry out a uniform application of the solution.

Meanwhile, solution B (a second mixed solution) is prepared by mixing and dissolving water, acting as an oligomerizer, in a second nonaqueous organic solvent (a second organic solvent) until a saturated state is reached. In cases in which water is used as the oligomizer, it is preferable to use water in which particles have been removed by a method such as filtration. When impurities such as particles are contained in the water, the particles are taken in by the silica-based coating film, and the uniformity of the silica-based coating layer may be degraded. The above-mentioned oligomerizer is not limited to water, and it is possible to use other substances as long as they have active hydrogens with valences of 2. Specifically, examples include amines such as methylamine and ethanolamine, and ammonias.

It is to be noted that the above-mentioned first and second nonaqueous organic solvents are of course included in the group of nonaqueous organic solvents described previously. This is because these nonaqueous first and second organic solvents together make up a nonaqueous organic solvent. Thus, for the above-described first and second nonaqueous organic solvents, it is possible to use any variety of the organic solvents described previously. In addition, among the examples given for organic solvents, a nonaqueous, nonpolar solvent is preferable for the first nonaqueous organic solvent, and in cases where water is mixed in as the oligomerizer, a nonaqueous, polar solvent is preferable for the second nonaqueous organic solvent.

Next, the above-described solution A and solution B are mixed in a dry atmosphere and set aside for a prescribed length of time. Thereby, dehydrochlorination is brought about between the chlorosilane compound and the water, and a solution for forming a silica-based coating film which contains chlorosiloxane oligomer, represented by the above-described general formula (I), is obtained. The mixing ratio of the above-described solution A and solution B is fixed such that the mole ratio of the water to the chlorosilane compound is equimolar or less. Consequently, even if there is dehydrochlorination between the chlorosilyl groups, acting as the activating groups, in the chlorosilane compound and hydroxyl groups (-OH) in the water molecules, because there are a greater number of chlorosilyl groups than the above-mentioned hydroxyl groups, the reaction is controlled so that not all of the chlorosilyl groups react. The reaction is controlled in this way so that deterioration in the activity of the solution for forming a silica-based coating film itself due to a decrease in remaining chlorosilyl groups in the prepared solution and the resulting decline in reactivity is prevented.

The solution A and the solution B are mixed in a dry atmosphere as mentioned above, for the following reasons. For example, if the solution A and the solution B were mixed in an atmosphere with a relative humidity of greater than 35%, the resulting mixed solution would become cloudy. This indicates dehydrochlorination between the moisture contained in the atmosphere and the chlorosilyl groups in the chlorosilane compound, and a worsening in the reactivity of the chlorosilane compound. As a result, as described previously, the number of chlorosilyl groups, acting as activating groups, decreases, and the activity of the solution for forming a silica-based coating film itself deteriorates. Thus, it is necessary to carry out the mixing of the solution A and the solution B in an atmosphere having a relative humidity of 35% or less.

Next, a silica-based coating film according the present Embodiment 1 is explained in detail. The silica-based coating film of this invention is a coating film in which the above-described siloxane compound having a plurality of activating groups, the constitutional unit, is chemically adsorbed to a surface of a substrate material such that the coating film takes on a network structure.

More specifically, it is as follows. A silica-based coating film 13, as illustrated in Fig. 2, is formed on a substrate material 11 by siloxane bonds (-SiO-). A plurality of polysiloxane oligomers, while being physically entangled, form a network structure strongly bound by chemical cross-linking bonds as in the repeating structural unit represented by the structural formula (V) below: 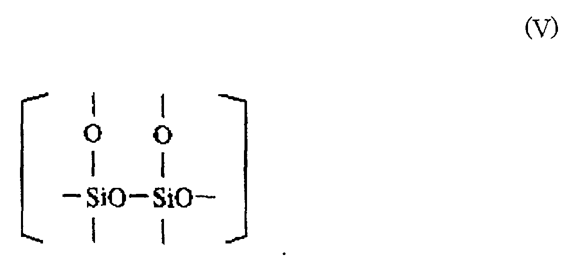 Consequently, the silica-based coating film 13 according to the present invention is excellent in terms of abrasion resistance and scratch resistance. Moreover, as clearly shown in Fig. 2, impurities such as hydrocarbon groups are not contained in the silica-based coating film 13. This is because the silica-based coating film 13 is made of a chlorosilane compound that does not contain impurities such as hydrocarbon groups and because catalysts and the like are not added. Because, as stated above, the silica-based coating film 13 does not contain impurities such as hydrocarbon groups, it is very high-grade for a silica-based coating film and is excellent in terms of hardness and transparency. When this kind of high-grade silica-based coating film 13 is used for the undercoat film of the substrate material 11, excellent blocking function against impurity ions and the like is demonstrated. Moreover, with the introduction of hydroxyl groups (-OH) onto the silica-based coating film 13, mainly onto the surface portion thereof, the coating film becomes a hydrophilic coating film. Therefore, when used, for example, in a liquid crystal display device, it can be used as the underlayer of the alignment film.

The above-mentioned substrate material 11 is not particularly limited, and it is possible to use, for example, a substrate material on a surface of which there are functional groups having active hydrogens such as hydroxyl groups (-OH) and imino groups (>NH). In particular, in this invention, the silica-based coating film 13 is effective with a substrate material having a heat resistance temperature of 150°C or less (the reason for this is stated in the explanation of the manufacturing method for the silica-based coating film). Specific examples include substrate materials comprising glass, plastic, ceramic, metal, fiber, leather, or paper. When the silica-based coating film 13 of this invention is formed onto a surface of a substrate material comprising glass, the elution of alkali from the glass can be prevented. In the case of ceramic or metal, the silica-based coating film exhibits the function of a protective film, and it is possible to improve the acid resistance of a substrate material as in, for example, suppressing reactions with chemicals. In the case of fiber, leather, and paper, it is possible to improve the hydrophily of a surface of the substrate material. For example, when the present invention is applied to nylons or stockings, it is possible to improve the feel. When it is applied to wigs, antistatic effects are exhibited.

On the other hand, when the above-mentioned substrate material 11 is composed of a substrate material in which there are no functional groups having active hydrogens or in which there are inherently few functional groups, by carrying out the treatment described below, it is possible to apply these substrate materials to the present invention. Namely, functional groups having active hydrogens should be introduced onto a surface of a substrate material by subjecting the surface of the substrate material to corona treatment in the air or to oxygen plasma treatment. Consequently, dehydrochlorination with chlorosilyl groups becomes possible. Examples for the above-mentioned substrate material include specifically, water repellent plastic such as an acrylic plate or a polycarbonate plate.

Next, a manufacturing method of the silica-based coating film according to Embodiment 1 of the present invention is described in detail. It is to be noted that, for the sake of convenience, the following explanation is based on an example in which a chlorosiloxane oligomer is used as the siloxane compound having activating groups in a solution for forming a silica-based coating film. However, it is of course possible to carry out the manufacturing process in the same way using other siloxane compounds having activating groups.

The above-mentioned silica-based coating film 13 is obtained by putting a surface of the above-described substrate material 11 in contact with the above-described solution for forming a silica-based coating film in a dry atmosphere, and then causing the solution to react with water.

More specifically, a degreased substrate material 11 is prepared by thoroughly washing the substrate material beforehand, and the solution for forming a silica-based coating film is applied to the substrate material 11 in a dry atmosphere to form an application film (applying step). Thereby, dehydrochlorination is brought about between chlorosilyl groups in the chlorosiloxane oligomer of the solution and functional groups, on the surface of the substrate material 11, having active hydrogens such as -OH groups or >NH groups, and covalent bonds (siloxane bonds) form with a surface of substrate material 11. The application method for the solution for forming a silica-based coating film is not particularly limited, and it is possible to employ known methods. Specific examples include spin coating, roll coating, dip coating, spray coating, screen printing, and brush coating. It is to be noted that the above-mentioned degreasing is carried out to improve the adhesion of the solution for forming a silica-based coating film with the substrate material 11, and that other known surface treatment methods may be carried out.

Next, by setting aside the substrate material 11 on which the solution has been applied at room temperature, the nonaqueous organic solvent in the above-described application film is evaporated (drying step). A chlorosiloxane oligomer coating film 12 as shown in Fig. 1 is thereby formed. It is to be noted that the chlorosilane compound exists in the application film in the form of a chlorosiloxane oligomer and it does not evaporate with the nonaqueous organic solvent.

Thereafter, the substrate material 11 on which the chlorosiloxane oligomer coating film 12 has been formed is put in an atmosphere containing moisture (forming silica-based coating film step). Thereby, dehydrochlorination between remaining chlorosilyl groups and water is instantly brought about. As a result, the interior of the film has a cross-linked structure, hydroxyl groups are introduced on the surface of the film, and a silica-based coating film 13 according to the present invention is formed (see Fig. 2). It is to be noted that although the method of putting the chlorosiloxane oligomer coating film 12 in contact with moisture is not particularly limited, the method of putting it in an atmosphere containing moisture as described previously is preferable. For example, if the chlorosiloxane oligomer coating film 12 were immersed in water, there would be immediate dehydrochlorination between remaining chlorosilyl groups in the chlorosiloxane oligomer coating film 12 and the film would become cloudy. Thus, because the silica-based coating film 13 would not be able to be formed on the substrate material 11, immersion in water is not preferable.

Furthermore, after the above-described step of forming a silica based coating film, a heat treatment step may be carried out to remove water. Hydroxyl groups are thereby removed, and it is possible to obtain a silica-based coating film 13 that is even more highly dense and very compact. As for the heating temperature in the above-mentioned heat treatment step, it should be within the substrate material 11's acceptable heat resistance range and be such that the water can sufficiently evaporate. It is preferable that the above-mentioned heating temperature be 100°C, the boiling point of water, or higher, and it is more preferable that it be 120°C or higher so that the length of heat treatment is shortened.

In addition, in the manufacturing method for the silica-based coating film 13 of the present invention, it is possible to add alkoxysilane compound to the solution for forming a silica-based coating film beforehand. In manufacturing methods for prior art silica-based coating films, it is necessary to add an acid catalyst along with the alkoxysilane compound, but in the present invention, it is not necessary to add an acid catalyst. This is because hydrochloric acid is produced by dehydrochlorination between chlorosilyl groups in the chlorosiloxane oligomer and hydroxyl groups. Because hydrochloric acid fulfills the role of an acid catalyst, dealcoholization, as represented by the reaction formula (X) below, is brought about. Consequently, hydroxyl groups are introduced into the above-mentioned alkoxysilane compound.

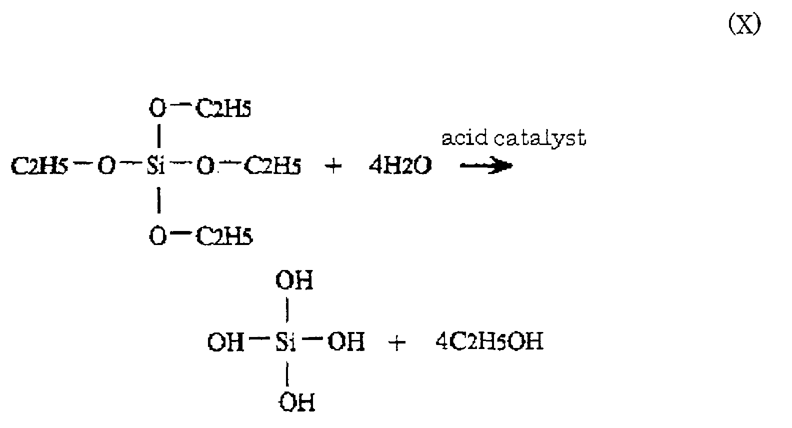

When the heat treatment step is carried out, dehydration, as represented by the reaction formula (XI) below, is brought about, and it is possible to obtain a silica-based coating film 13 that is even more highly dense and very compact. 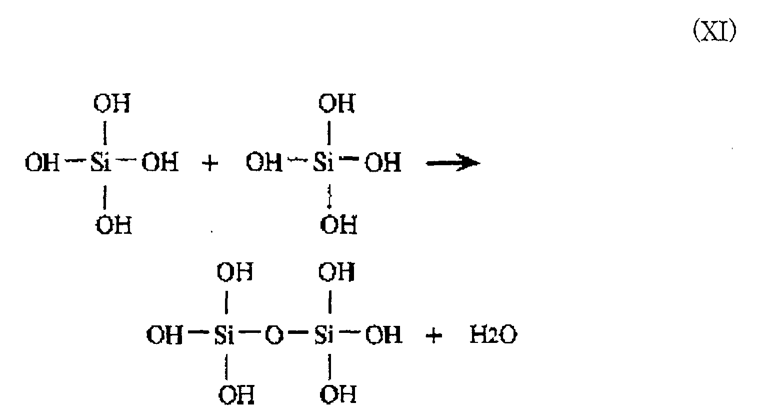 It is to be noted that, the above-mentioned alkoxylsilane compound is not particularly limited, and specific examples include tetraethoxysilane and propyloxysilane.

In addition, if the solution for forming a silica-based coating film is diluted or concentrated, it is possible to control the thickness of the silica-based coating film. Thereby, it is possible to form a silica-based coating film at a desired thickness. It is to be noted that when the solution is diluted, the diluting solvent is not particularly limited and the organic solvents described previously may be used.

Considering the above, by employing the manufacturing method for the silica-based coating film according to Embodiment 1, the addition of a catalyst and heat treatment steps carried out in prior art manufacturing methods are not necessary, and thus it is possible to form a silica-based coating layer very simply. Moreover, it is possible to form a silica-based coating layer on a surface of a substrate material comprising a material with low heat resistance.

In the above explanation, the first aspect of the present invention has been explained by following the most suitable example, but the present invention can be suitably applied to any articles that have used a silica-based coating film. For example, it can be used for an interlayer insulating film, or a passivation film of a semiconductor device. In addition, it can be used as a planarizing film disposed between a transparent substrate and a transparent electrode in a liquid crystal device, or as the underlayer of an alignment film disposed between a transparent electrode and the alignment film. Furthermore, it can be used as a passivation film for a thin film transistor array used in a liquid crystal device. Moreover, the present invention is not limited to these uses, and it is suitable for use with a substrate material having low heat resistance. For example, it can be used for the hard coat layer of eyeglass lenses and the like, which have low heat resistance.

### EMBODIMENT 2

The present Embodiment 2 corresponds to the second aspect of the present invention.

First, a solution for forming a silica-based coating film according to the present Embodiment 2 is described in detail. The solution for forming a silica-based coating film is composed such that it contains a nonaqueous organic solvent and a compound in which a silane compound having activating groups is bonded to anhydrous silica fine particles and titanium oxide fine particles.

The above-mentioned anhydrous silica fine particles have an average particle diameter of approximately several nanometers to several hundreds of nanometers, and adsorbed water does not exist on the surface of the particles. On the other hand, functional groups having active hydrogens (for example, -OH groups) do exist on the surface of the particles, and it is possible for the functional groups to react with activating groups such as chlorosilyl groups. Examples of the above-described anhydrous silica fine particles include Aerosil 200 and Aerosil 300 available from Nippon Aerosil Co., Ltd.

In addition, the titanium oxide fine particles, like the above-described anhydrous silica fine particles, have an average particle diameter of approximately several nanometers to several 100 nanometers, and while adsorbent water does not exist on the surface of the particles, functional groups having active hydrogens do exist on the surface of the particles. An example of the above-described titanium oxide fine particles is P25 available from Nippon Aerosil Co., Ltd.

By adding anhydrous silica and titanium oxide fine particles to the solution for forming a silica-based coating film, it is possible to control the viscosity of the solution and to improve film coatability. Specifically, by varying the amount of anhydrous silica fine particles added and the amount of nonaqueous organic solvent as needed, it is possible to control the viscosity. It is preferable that the mixing density of the above-mentioned anhydrous silica fine particles with respect to the solution for forming a silica-based coating film be within the range of approximately 0.01 to 20 wt.%, and it is more preferable that it be within the range of 0.1 to 10 wt.% so far as the viscosity and film coatability are concerned. It is not preferable for the above-mentioned mixture density to exceed 20 wt.% because the viscosity of the solution for forming a silica-based coating film increases too much and the handleability worsens. On the other hand, it is also not preferable for the mixture density to be less than 0.01 wt.% because the positive effects of adding anhydrous silica fine particles and the like diminish. For example, it becomes more difficult to control the viscosity of the solution or to form a thick silica-based coating film.

The above-described silane compound having activating groups is represented by, for example, the general formula (VI) below: 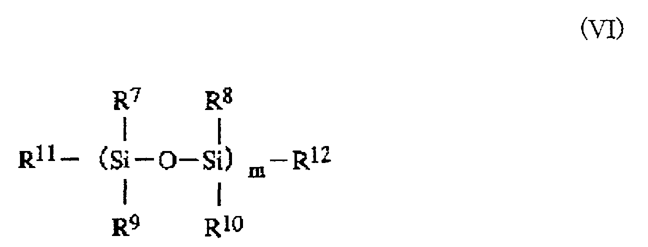 wherein R⁷ to R¹⁰, independently of one another, are a hydrogen atom, a halogen, an isocyanate group, a hydroxyl group, a functional group containing a chlorosilyl group, a functional group containing a dichlorosilyl group, a functional group containing a trichlorosilyl group, a functional group containing a silanol group, or a silicon-containing functional group in which cross-linking can be obtained by forming siloxane bonds; R₁₁ and R₁₂, independently of one another, are a hydrogen atom, a halogen, an isocyanate group, or a hydroxyl group; and m is an integer of 1 or greater.

The above-described silane compound having activating groups is not limited to a chain compound that has a linear structure, branched structure, or the like, and a cyclic compound may be used. In addition, in the general formula (VI), m is an integer of 1 or greater, but it is preferable that m be within the range of 2 to 1000, a degree of polymerization approximately equal to that of an oligomer, and it is even more preferable that m be within the range of 4 to 100. When a silane compound having a degree of polymerization greater than that of an oligomer, as when m is greater than 1000, is contained in the solution for forming a silica-based coating film, the viscosity of the solution itself increases and the handleability worsens.

The above-described silane compound having activating groups, as represented by the general formula (VI), specifically, may contain one, or two or more compounds selected from the group consisting of the compounds represented by the general formula (VII), the general formula (VIII), and the general formula (IX) below: 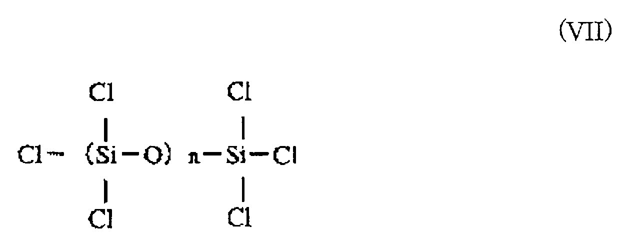 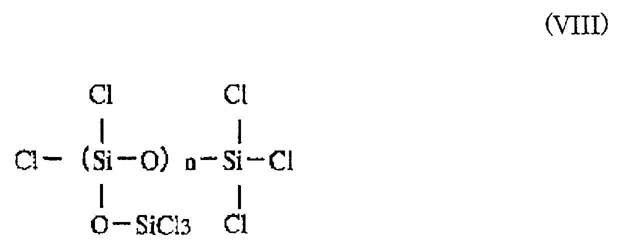 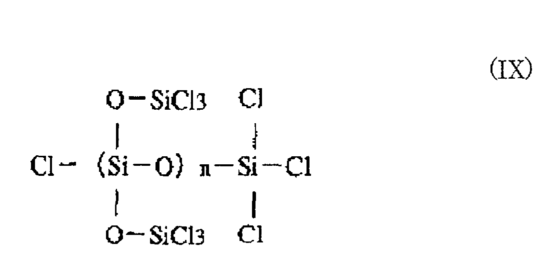 wherein n is an integer of 1 or greater.

It is to be noted that in the general formulas (VII) to (IX) above, n is an integer of 1 or greater, but it is preferable that n be within the range of 2 to 1000, a degree of polymerization approximately equal to that of an oligomer, and it is more preferable that n be within the range of 4 to 100.

The anhydrous silica fine particles and the silane compound having activating groups are as explained above, but in the solution for forming a silica-based coating film according to the present invention, the particles and the compound are bonded and dispersed in the solution. Namely, hydroxyl groups that exist on the surface of the anhydrous silica fine particles and activating groups in the silane compound react to form siloxane bonds, as, for example, represented by the general formula (XII) below: 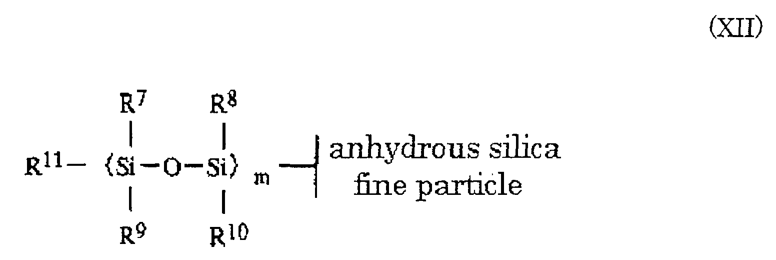 wherein R⁷ to R¹⁰, independently of one another, are a hydrogen atom, a halogen, an isocyanate group, a hydroxyl group, a functional group containing a chlorosilyl group, a functional group containing a dichlorosilyl group, a functional group containing a trichlorosilyl group, a functional group containing a silanol group, or a silicon-containing functional group in which cross-linking can be obtained by forming siloxane bonds; R₁₁ and R₁₂, independently of one another, are a hydrogen atom, a halogen, an isocyanate group, or a hydroxyl group; and m is an integer of 1 or greater.

In addition, the bonds between the anhydrous silica fine particles and the silane compound are not limited to the bond of the example above, and other variations are possible as long as at least one of R₇ to R₁₂ in the general formula (VI) bonds with an anhydrous silica fine particle.

Moreover, when the silane compound having activating groups is one of the chlorosilane compounds represented by the previously described general formulas (VII) to (IX), the bonds with the anhydrous silica fine particles are siloxane bonds formed by dehydrochlorination between SiCl groups in each chlorosilane compound and the OH groups on the anhydrous silica fine particles. In each chlorosilane compound, sites that are bonded by siloxane bonds may form at any of and at least one of the bonding sites where a SiCl group is present.

For the above-mentioned nonaqueous organic solvent, solvents containing one, or two or more organic solvents selected from the group consisting of a hydrocarbon-based organic solvent, a fluorine-based organic solvent, and a chlorine-based organic solvent can be used. The above-mentioned hydrocarbon-based organic solvent is not particularly limited, and specific examples include n-hexane, toluene, cyclohexane, isooctane, and dimethyl silicon. In addition, the above-mentioned fluorine-based organic solvent is not particularly limited, and an example is perfluorooctane. The above-mentioned chlorine-based solvent also is not particularly limited, and an example is chloroform. By using these nonaqueous organic solvents, there is the advantage of being able to easily remove water from the nonaqueous organic solvents. Moreover, because among organic solvents, nonaqueous organic solvents absorb little moisture, reaction between activating groups in the silane compound and excess water can be prevented. Thereby, a solution for forming a silica-based coating film which contains many activating groups is excellent in terms of film coatability and has a high reactivity can be prepared. In addition, the boiling points of the nonaqueous organic solvents used for the present invention are low in comparison to the boiling points of organic solvents used for prior art solutions for forming a silica-based coating film. For this reason, it is possible to evaporate the nonaqueous organic solvents at room temperature without carrying out heat treatment. Thus, a solution for forming a silica-based coating film which has excellent handleability can be provided.

Next, a manufacturing method of the solution for forming a silica-based coating film according to the present Embodiment 2 will be described in detail. First, a solution C (a third mixed solution) is prepared by mixing a silane compound having activating groups and anhydrous silica fine particles in a first nonaqueous organic solvent.

At this time, the silane compound having activating groups and the anhydrous silica fine particles in the solution C bond by forming siloxane bonds. The amount of anhydrous silica fine particles added is adjusted so that the viscosity value of the finished solution for forming a silica-based coating film is as desired. When this solution C is prepared, the preparation is carried out in a dry atmosphere, for example, dry air, dry nitrogen, or dry helium, such that the relative humidity is within the range of 35% or less. When the relative humidity exceeds 35%, the moisture in the atmosphere and activating groups in the silane compound excessively react, causing the solution to become clouded. An example of the silane compound having activating groups is a chlorosilane compound. Examples for the above-mentioned chlorosilane compound include tetrachlorosilane (SiCl₄), trichlorosilane (SiHCl₃), dichlorosilane (SiH₂Cl₂), hexachlorodisiloxane (ClSiCl₂OSiCl₃), and octachlorotrisiloxane (Cl(SiCl₂O)₂SiCl₃). It is desirable to use at least one compound selected from this group to obtain a silica-based coating film that does not contain impurities such as hydrocarbon groups. It is to be noted that it is preferable that the concentration of the silane compound having activating groups dissolved in the first nonaqueous organic solvent be within the range of 0.01 M/L to 10 M/L. When the concentration is less than 0.01 M/L, the positive effects of forming a silica-based coating film, namely the numerous positive effects for the substrate material, are diminished. On the other hand, when the concentration is greater than 10 M/L, it is difficult, when the solution for forming a silica-based coating film is used, to carry out a uniform application of the solution.

Meanwhile, a solution D (a fourth mixed solution) is prepared by mixing and dissolving water in a second nonaqueous organic solvent until a saturated state is reached. For the above-mentioned water, it is preferable to use water in which particles have been removed by a method such as filtration. When impurities such as particles are contained in the water, the particles are taken in by the silica-based coating film, and the uniformity of the silica-based coating layer may be degraded.

It is to be noted that the above-mentioned first and second nonaqueous organic solvents are of course included in the group of nonaqueous organic solvents described previously. This is because these nonaqueous first and second organic solvents together make up a nonaqueous organic solvent. Thus, for the above-described first and second nonaqueous organic solvents, it is possible to use any variety of the organic solvents described previously. In addition, among the examples given for organic solvents, a nonaqueous, nonpolar solvent is preferable for the first nonaqueous organic solvent, and because water is dissolved in the solvent, a nonaqueous, polar solvent is preferable for the second nonaqueous organic solvent.

Next, the above-described solution C and solution D are mixed in a dry atmosphere, and set aside for a prescribed length of time. Thereby, dehydrochlorination is brought about between the silane compound having activating groups which are bound with the anhydrous silica particles and the water, and a solution for forming a silica-based coating film in which the compound represented by the above-described general formula (XII) is dispersed, is obtained. The mixing ratio of the above-described solution C and solution D is fixed such that the mole ratio of the water to the silane compound having activating groups is equimolar or less. Consequently, even if the activating groups in the above-described silane compound react with the hydroxyl groups (-OH) in the water molecules, because there are a greater number of activating groups than the above-mentioned hydroxyl groups, the reaction is controlled so that not all of the activating groups react. The reaction is controlled in this way so that deterioration in the activity of the solution for forming a silica-based coating film itself, due to the decrease in remaining activating groups in the prepared solution and the resulting decline in reactivity, is prevented.

The solution C and the solution D are mixed in a dry atmosphere as mentioned above, for the following reasons. For example, if the solution C and the solution D were mixed in an atmosphere with a relative humidity of greater than 35%, the resulting mixed solution would become cloudy. This indicates dehydrochlorination between the moisture contained in the atmosphere and the activating groups in the silane compound and a worsening in the reactivity of the silane compound having activating groups. As a result, as described previously, the number of activating groups decreases, and the activity of the solution for forming a silica-based coating film itself deteriorates. Thus, it is necessary to carry out the mixing of the solution C and the solution D in an atmosphere having a relative humidity of 35% or less.

It is to be noted that in the above-described manufacturing method for a solution for forming a silica-based film, the anhydrous silica fine particles are added to the solution C, but the present invention is not only limited to this case, and it is possible to add the anhydrous silica fine particles to the solution D. Alternatively, it is possible to add the anhydrous silica fine particles to both the solution C and the solution D.

Next, a silica-based coating film according to the present Embodiment 2 is explained in detail. The silica-based coating film of this invention is a coating film in which polysiloxane oligomers, a polysiloxane oligomer being the constitutional unit, are chemically adsorbed to a surface of a substrate material as well as to anhydrous silica fine particles such that the coating film takes on a network structure.

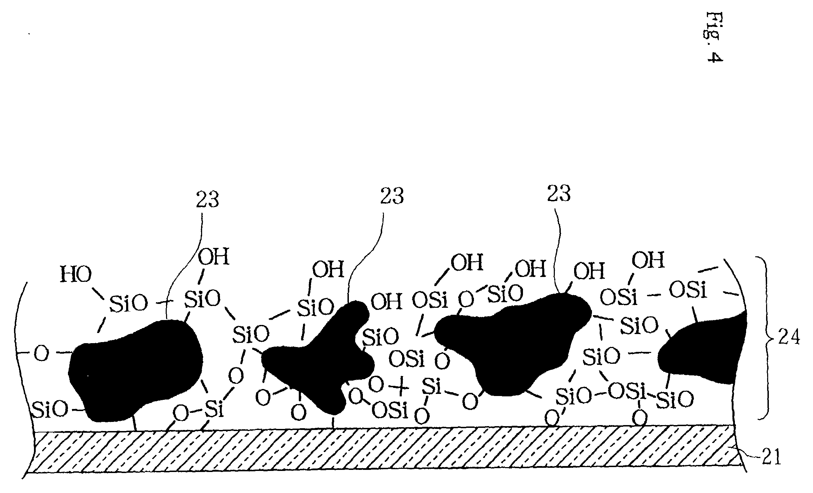

More specifically, it is as follows. As illustrated in Fig. 4, a plurality of polysiloxane oligomers which make up the silica-based coating film 24 are physically entangled and form a network structure strongly bound by chemical cross-linking bonds as in the repeating structural unit represented by the structural formula (V) below: 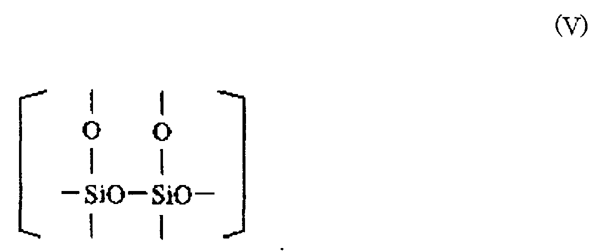 In addition, the above-mentioned polysiloxane oligomers are formed on the substrate material 21 as well as on the surface of the anhydrous silica fine particles 23 by siloxane bonds (-SiO-). Moreover, as clearly shown in Fig. 4, the anhydrous silica fine particles 23 are contained in the structure in such a way that the particles form siloxane bonds with the substrate material 21. Consequently, the silica-based coating film 24 according to the present invention is excellent in terms of abrasion resistance and scratch resistance. Furthermore, polysiloxane oligomers having hydrocarbon groups and the like are not contained in the silica-based coating film 24. This is because the silica-based coating film 4 is made of a silane compound that does not contain hydrocarbon groups and the like and because catalysts and the like are not added.

Because, as stated above, the silica-based coating layer 24 does not contain hydrocarbon groups and the like, for a silica-based coating film, it is very high-grade and excellent in terms of hardness and transparency. When this kind of high-grade silica-based coating film 24 is used for the undercoat film of the substrate material 21, excellent blocking function against impurity ions and the like is exhibited. Moreover, with the introduction of hydroxyl groups (-OH) onto the silica-based coating film 24, mainly onto the surface thereof, the coating film becomes a hydrophilic coating film. Therefore, when used, for example, in a liquid crystal display device, it can be used as the underlayer of the alignment film.

The above-mentioned substrate material 21 is not particularly limited, and it is possible to use, for example, a polymer substrate material on a surface of which there are functional groups having active hydrogens such as hydroxyl groups (-OH) and imino groups (>NH). In particular, the silica-based coating film 24 is effective with a substrate material having a heat resistance temperature of 150°C or less (the reason for this is stated in the explanation of the manufacturing method for the silica-based coating film). Specific examples include substrate materials comprising glass, ceramic, plastic, metal, fiber, leather, or paper. When the silica-based coating film 24 of this invention is formed on a surface of a substrate material comprising glass, the elution of alkali from the glass can be prevented. In the case of ceramic or metal, the silica-based coating film exhibits the function of a protective film, and it is possible to improve the acid resistance of a substrate material as in, for example, suppressing reactions with chemicals. In the case of fiber, leather, and paper, it is possible to improve the hydrophily of a surface of the substrate material. For example, when the present invention is applied to nylons or stockings, it is possible to improve the feel. When it is applied to wigs, antistatic effects are exhibited.

On the other hand, when the above-mentioned substrate material 21 is composed of a substrate material in which there are no functional groups having active hydrogens or in which there are inherently few functional groups, by carrying out the treatment described below, it is possible to apply these substrate materials to the present invention. Namely, functional groups having active hydrogens should be introduced onto a surface of a substrate material by subjecting the surface of the substrate material to corona treatment in the air or to oxygen plasma treatment. Consequently, dehydrochlorination with chlorosilyl groups becomes possible. Examples for the above-mentioned substrate material include specifically, water repellent plastic such as an acrylic plate, or a polycarbonate plate.

Next, a manufacturing method of the silica-based coating film according to Embodiment 2 of the present invention is described in detail. It is to be noted that, for the sake of convenience, the following explanation is based on an example in which a chlorosiloxane oligomer is used as the silane compound having activating groups in the solution for forming a silica-based coating film. However, it is of course possible to carry out the manufacturing process in the same way using other silane compounds having activating groups.

The above-mentioned silica-based coating film 24 is obtained by putting a surface of the above-described substrate material 21 in contact with the above-described solution for forming a silica-based coating film in a dry atmosphere, and then causing the solution to react with water.

More specifically, a degreased substrate material 21 is prepared by thoroughly washing the substrate material beforehand, and the solution for forming a silica-based coating film is applied to the substrate material 21 in a dry atmosphere to form an application film (applying step). Thereby, dehydrochlorination is brought about between chlorosilyl groups in the chlorosiloxane oligomer of the solution and functional groups, on the surface of the substrate material 21, having active hydrogens such as -OH groups or >NH groups, and in a state such that anhydrous silica fine particles are contained in the solution, the chlorosilyl groups form covalent bonds (siloxane bonds) with the substrate material 21. The application method for the solution for forming a silica-based coating film is not particularly limited, and it is possible to employ known methods. Specific examples include spin coating, roll coating, dip coating, spray coating, screen printing, and brush coating. In particular, by the addition of the anhydrous silica fine particles 23, the viscosity of the solution for forming a silica-based film can be easily adjusted and film coatability improved.

For reference, the solution for forming a silica-based coating film can be suitably used when its viscosity is from several thousand to several ten thousands centipoises. In addition, the above-mentioned degreasing is carried out to improve the adhesion of the solution for forming a silica-based coating film with the substrate material 21, and other known surface treatment methods may be carried out.

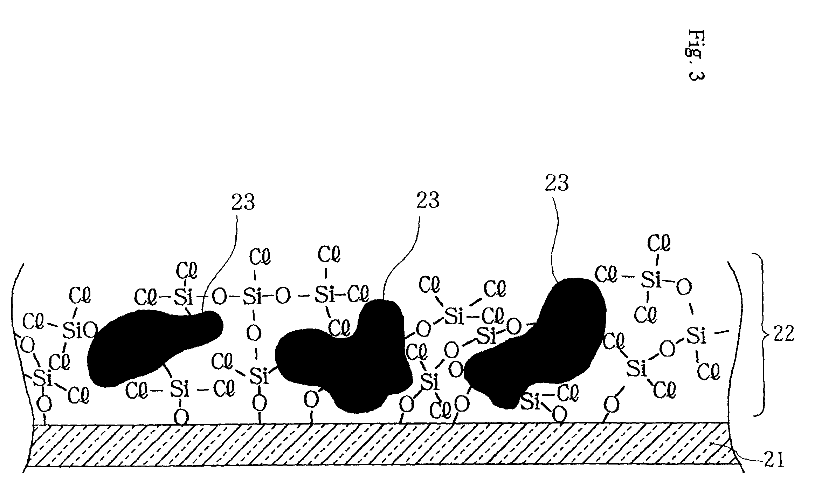

Next by setting aside the substrate material 21 on which the solution has been applied at room temperature, the nonaqueous organic solvent in the above-described application film is evaporated (drying step). A chlorosiloxane oligomer coating film 22 as shown in Fig. 3 is thereby formed. It is to be noted that the silane compound having activating groups exists in the application film in the form of a chlrosiloxane oligomer, and it does not evaporate with the nonaqueous organic solvent.

Thereafter, the substrate material 21 on which the chlorosiloxane oligomer coating film 22 has been formed is put in an atmosphere containing moisture (step of forming of silica-based coating film). Thereby, dehydrochlorination between remaining chlorosilyl groups and water is instantly brought about. As a result, the interior of the film has a cross-linked structure, hydroxyl groups are introduced on the surface of the film, and a silica-based coating film 24 according to the present invention is formed (see Fig. 3). It is to be noted that although the method of putting the chlorosiloxane oligomer coating film 22 in contact with moisture is not particularly limited, the method of putting it in an atmosphere containing moisture as described previously is preferable. For example, if the chlorosiloxane oligomer coating film 22 were immersed in water, there would be immediate dehydrochlorination between remaining chlorosilyl groups in the chlorosiloxane oligomer coating film 22 and the film would become cloudy. Thus, because the silica based coating film 23 would not be able to be formed on the substrate material 21, immersion in water is not preferable.

Furthermore, after the above-described step of forming a silica based coating film (Fig. 3), a heat treatment step may be carried out to remove water. Hydroxyl groups are thereby removed, and it is possible to obtain a silica-based coating film 24 that is even more highly dense and very compact. As for the heating temperature in the above-mentioned heat treatment step, it should be within the substrate material 21's acceptable heat resistance range and be such that the water can sufficiently evaporate. It is preferable that the above-mentioned heating temperature be 100°C, the boiling point of water, or higher, and it is more preferable that it be 120°C or higher so that the length of heat treatment is shortened.

In addition, in the manufacturing method for the silica-based coating film 24 of the present invention, it is possible to add an alkoxysilane compound to the solution for forming a silica-based coating film beforehand. In manufacturing methods for prior art silica-based coating films, it was necessary to add an acid catalyst along with the alkoxysilane compound, but in the present invention, it is not necessary to add an acid catalyst. This is because hydrochloric acid is produced by dehydrochlorination between chlorosilyl groups in the chlorosiloxane oligomer and hydroxyl groups. Because hydrochloric acid fulfills the role of an acid catalyst, dealcoholization, as represented by the reaction formula (X) below, is brought about. Consequently, hydroxyl groups are introduced into the above-mentioned alkoxysilane compound.

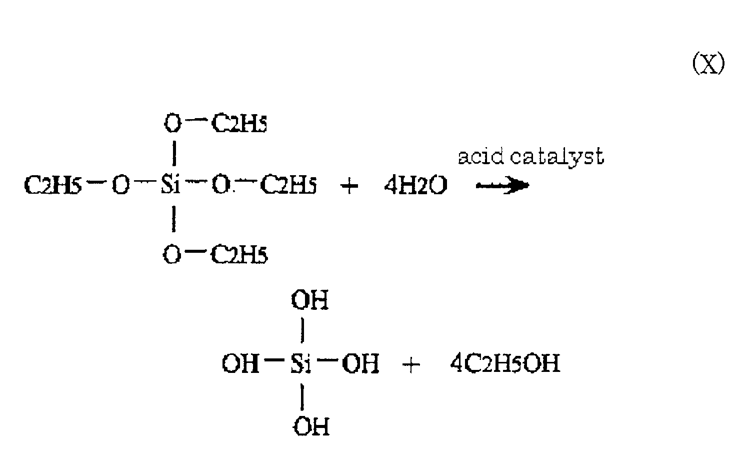

When the heat treatment step is carried out, dehydration, as represented by the reaction formula (XI) below, is brought about, and it is possible to obtain a silica-based coating film 13 that is even more highly dense and very compact. 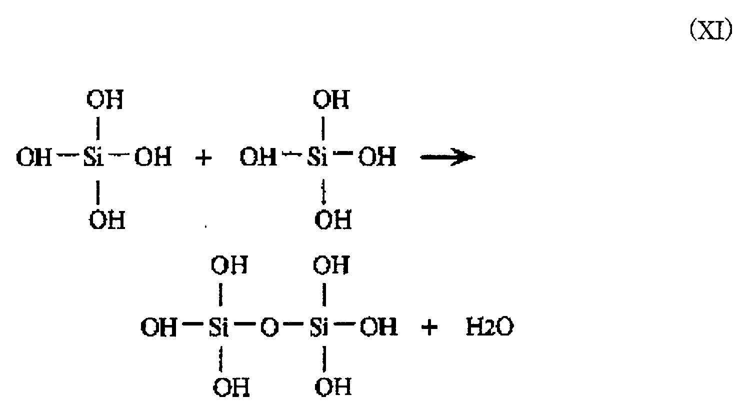 It is to be noted that, the above-mentioned alkoxylsilane compound is not particularly limited, and specific examples include tetraethoxysilane and propyloxysilane. However, among alkoxylsilane compounds, tetramethoxysilane should be avoided because it is highly toxic to humans.

In addition, if the solution for forming a silica-based coating film is diluted or concentrated, it is possible to control the thickness of the silica-based coating film. Moreover, by the addition of anhydrous silica fine particles, the viscosity of the application solution can be adjusted, and it is possible to form a silica-based coating film at a desired thickness. It is to be noted that when the solution is diluted, the diluting solvent is not particularly limited and the organic solvents described previously may be used.

Considering the above, by employing the manufacturing method for the silica-based coating film according to Embodiment 2, the addition of a catalyst and heat treatment steps carried out in prior art manufacturing methods are not necessary, and thus it is possible to form a silica-based coating layer very simply. Moreover, it is possible to form a silica-based coating layer on a surface of substrate material comprising a material with low heat resistance.

In the above explanation, the second aspect of the present invention has been explained by following the most suitable example, but the present invention can be suitably applied to any articles that have used a silica-based coating film. For example, it can be used for an interlayer insulating film, or a passivation film of a semiconductor device. In addition, it can be used as a planarizing film disposed between a transparent substrate and a transparent electrode in a liquid crystal device, or as the underlayer of an alignment film disposed between a transparent electrode and the alignment film. Furthermore, it can be used as a passivation film for a thin film transistor array used in a liquid crystal device. Moreover, the present invention is not limited to these uses, and it is suitable for use with a substrate material having low heat resistance. For example, it can be used for the hard coat layer of eyeglass lenses and the like, which have low heat resistance.

### SUPPLEMENTARY REMARKS

In addition, it is possible to use a solution for forming a silica-based coating film according to the present invention as an adhesive which bonds an object with another object. This is possible because, as long as the two objects have functional groups having activating groups on their surfaces, it is possible to form a silica-based coating film in the space between the objects by chemical adsorption on the surfaces of both objects, and as a result, the two objects can be joined and connected.

Therefore, by using a solution for forming a silica-based coating film as an adhesive, a bonded structure in which an object and another object are bonded together with a silica-based coating film disposed therebetween can be provided in the present invention.

In particular, a solution for forming a silica-based coating film of the present invention can be used as an adhesive in cases in which the objects are composed of materials such as glass fibers or glass fiber and another material.

A method of utilizing a solution for forming a silica-based coating film according to the present invention as an adhesive is as follows.

First, two objects, on the surfaces of which functional groups having active hydrogens exist, are prepared, and in a dry atmosphere, a solution for forming a silica-based coating film is applied to the surface of one object to form an application film (applying step). Thereby, dehydrochlorination is brought about between chlorosilyl groups in the chlorosiloxane oligomers of the solution and functional groups having active hydrogens which exist on the object's surface, and the chlorosilyl groups form siloxane bonds on the surface of the object. Next, in a dry atmosphere, the other object is secured and bonded to the above-mentioned object with the application film disposed therebetween (bonding step). Consequently, dehydrochlorination on the surface of this other object is brought about in the same way as it was on surface of the above-mentioned object, and chemical adsorption takes place.

Next, by setting aside the application film, which is in the space between the one object and the other object, at room temperature, the nonaqueous organic solvent in the application film is evaporated (drying step). Thereby, a chlorosiloxane oligomer coating film is formed.

Thereafter, the chlorosiloxane oligomer coating film is put in an atmosphere containing moisture (silica-based coating film forming step). By doing this, dehydrochlorination between remaining chlorosilyl groups and water is instantly brought about, causing the interior of the film to have a cross-linked structure. An adhesive structure according to the present invention can thus be prepared.

Moreover, a silica-based coating film formed by using a solution for forming a silica-based coating film in accordance with this invention, is particularly excellent in terms of transparency, and thus can be used particularly as paint (varnish) for forming a glossy, transparent coat. Furthermore, it can also be used as paint for forming a colored coat by adding any one member of the group consisting of a colorant, a dyestuff, or a pigment to the above-mentioned paint composition. The above-mentioned colorant, dyestuff, and pigment are not particularly limited, and it is possible to use known substances.

### EXAMPLES

Referring to the drawings, suitable examples of this invention are described in detail below. However, the materials used for the constituent elements, the treatment conditions, and the like detailed in these examples are for illustrative purposes only, and are not to be construed as limiting the scope of the invention.

### Example 1

The present Example 1 corresponds to the first aspect of the present invention and relates to the preparation of a solution for forming a silica-based coating film. More specifically, it is as follows.

First, the solution A (the first mixed solution) was prepared by mixing and dissolving tetrachlorosilane (SiCl₄), serving as the chlorosilane compound, in dimethyl silicon, serving as the first nonaqueous organic solvent, in an atmosphere having a relative humidity of 5%. The concentration of SiCl₄ in the solution A was made to be 0.1 M/L. Next, the solution B (the second mixed solution) was prepared by mixing and dissolving water in chloroform, serving as the second nonaqueous organic solvent, until a saturated state was reached.

Thereafter, the above-described solution A and solution B were mixed in a dry atmosphere having a relative humidity of 5% such that the number of moles of SiCl₄ and the number of moles of water were the same, and the resulting solution was set aside for one night. With the mixing of the two solutions, dehydrochlorination was brought about between the SiCl₄ and the water, and a solution for forming a silica-based coating film containing chlorosiloxane oligomers was obtained.

When qualitative analysis (by liquid chromatography, infrared spectroscopy or the like) was carried out on the solution for forming a silica-based coating film of the present example, it was found that the solution contained substances represented by the general formulas, (II), (III), and (IV) below: 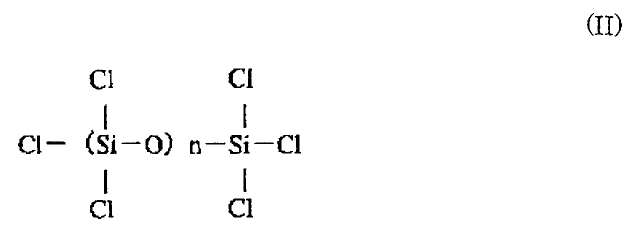 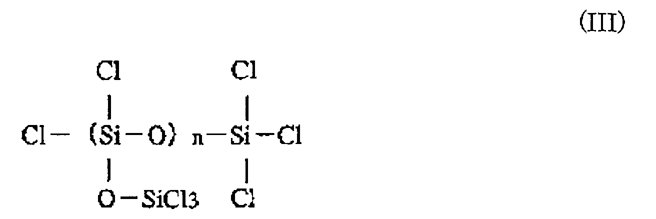 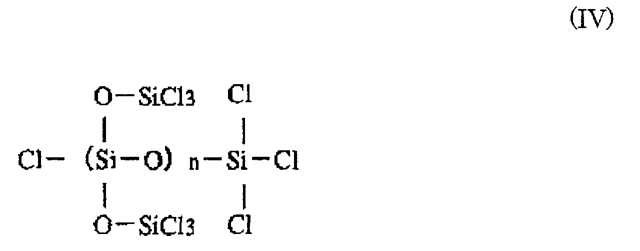 wherein n is an integer of 1 or greater.

### Example 2

In the present example, a solution for forming a silica-based coating film prepared in the same manner as Example 1 was used to carry out the forming of a silica-based coating film.

First, a substrate material 11 composed of glass was degreased by thoroughly washing the substrate material 11 beforehand. Next, the solution for forming a silica-based coating film was applied to the surface of the substrate material 11 in an atmosphere having a relative humidity of 5%. At room temperature, the dimethyl silicon and the chloroform were evaporated, and a chlorosiloxane oligomer coating film 12 was thus formed (see Fig. 1).

Thereafter, the substrate material 11, on which the chlorosiloxane oligomer coating film 12 was formed, was exposed in an atmosphere containing moisture, causing a reaction between the water and the chlorosiloxane oligomer. By doing this, a silica-based coating film 13 having a thickness of approximately 8 nm was formed (see Fig. 2). Through analysis, it was confirmed that the above-mentioned silica-based coating film 13 was composed such that it contained the constitutional unit represented by the structural formula (XIII) below:

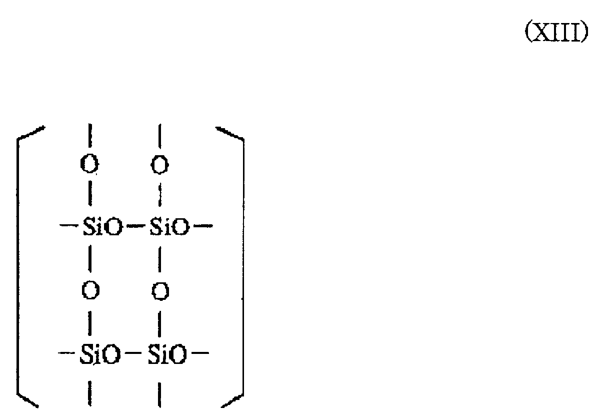

By the process described above, a silica-based coating film 13 in accordance with the present example was obtained.

### Example 3

The present Example 3 corresponds to the second aspect of the present invention and relates to the preparation of a solution for forming a silica-based coating film. More specifically, it is as follows.

First, the solution C (the third mixed solution) was prepared by mixing and dissolving anhydrous silica fine particles (Nippon Aerosil Co., Ltd., trade name: Aerosil 300) and tetrachlorosilane (SiCl₄), serving as a chlorosilane compound, in dimethyl silicon, serving as the first nonaqueous organic solvent, in an atmosphere having a relative humidity of 5%. The concentration of the SiCL₄ in the solution C was made to be 0.1 M/L. In addition, the Aerosil 300, serving as the anhydrous silica fine particles, was made to be 3 wt.%.

Next, the solution D (the fourth mixed solution) was prepared by mixing water in chloroform, serving as the second nonaqueous organic solvent, until a saturated state was reached. At this time, it is possible to add the anhydrous silica fine particles to the solution D or to add the anhydrous silica particles to both solutions.

Thereafter, the above-described solution C and solution D were mixed in a dry atmosphere having a relative humidity of 5% such that the number of moles of SiCl₄ and the number of moles of water were the same, and the resulting solution was set aside for one night. With the mixing of the two solutions, dehydrochlorination was brought about between the SiCl₄ and the water, and a solution for forming a silica-based coating film containing chlorosiloxane oligomers was obtained.

When qualitative analysis (by liquid chromatography, infrared spectroscopy or the like) was carried out on the solution for forming a silica-based coating film of the present example, it was found that the solution contained substances represented by the general formulas (VII), (VIII), and (IX) below: 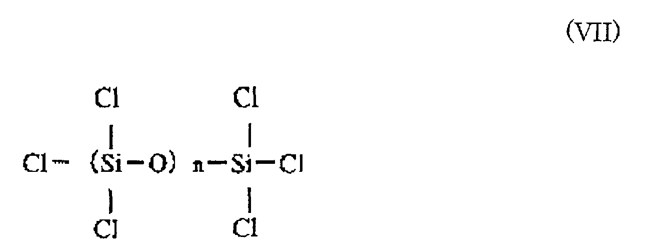 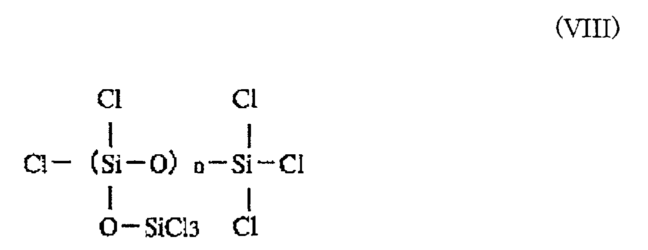 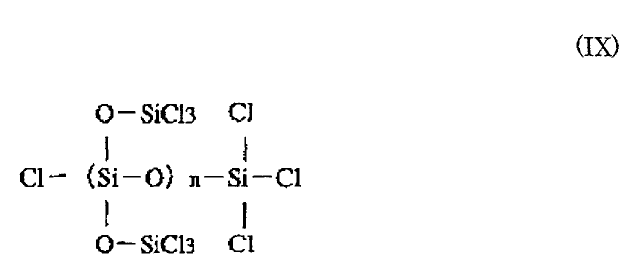 wherein n is an integer of 1 or greater.

### Example 4

In the present example, a solution for forming a silica-based coating film prepared in the same manner as Example 3 was used to carry out the forming of a silica-based coating film.

First, a substrate material 21 composed of glass was degreased by thoroughly washing the substrate material 21 beforehand. Next, the solution for forming a silica-based coating film was applied to the surface of the substrate material 21 in an atmosphere having a relative humidity of 5%. At room temperature, the dimethyl silicon and the chloroform were evaporated, and a chlorosiloxane oligomer coating film 22 containing anhydrous silica fine particles 23 was thus formed (see Fig. 3).

Thereafter, the substrate material 21, on which the chlorosiloxane oligomer coating film 22 was formed, was exposed in an atmosphere containing moisture, causing a reaction between the water and the chlorosiloxane oligomer. By doing this, a silica-based coating film 24 having a thickness of approximately 500 nm was formed (see Fig. 4). Through analysis, it was confirmed that the above-mentioned silica-based coating film 24 was composed such that it contained the constitutional unit represented by the structural formula (XIII) below: 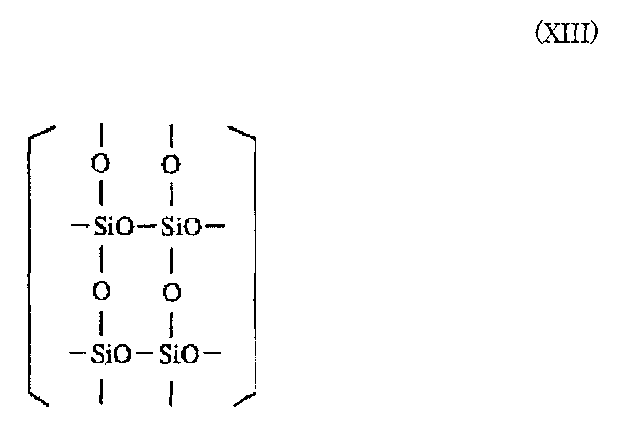 By the process described above, a silica-based coating film 24 in accordance with the present example was obtained.

Specific examples of the aspects of the invention set forth herein are intended to be illustrative, not limiting. Various changes may be made without departing from the spirit and scope of the invention as defined by the appended claims.

### INDUSTRIAL APPLICABILITY

The present invention may be carried out according to the preferred embodiments described above and exhibits the following advantageous effects.

With a solution for forming a silica-based coating film according to the first aspect of the present invention, by including a siloxane compound having activating groups in the solution for forming a silica-based coating film, the solution can be used without carrying out heat treatment or adding a catalyst as has been done in prior art methods such as the sol-gel method, and a solution for forming a silica-based coating film that is excellent in terms of reactivity with a substrate material can be provided.

In addition, in a manufacturing method for the solution for forming a silica-based coating film according to the first aspect of the present invention, by mixing, in a dry atmosphere, a first mixed solution, in which silane compound having activating groups has been dissolved in a dry atmosphere, and a second mixed solution, in which water, acting as an oligomerizer, has been dissolved, a solution for forming a silica-based coating film which contains a siloxane compound having activating groups is prepared. Because the siloxane compound having activating groups is produced by dehydrochlorination between the silane compound having activating groups and the water, a siloxane compound on which a large number of activating groups exist can be realized. Thus, a solution for forming a silica-based coating film that is excellent in terms of reactivity with a substrate material can be manufactured.

Moreover, because a silica-based coating film according to the first aspect of the present invention is chemically adsorbed to a surface of a substrate material by dehydrochlorination and because it has a network structure of cross-linking bonds formed by siloxane bonds, the silica-based coating film can be used as a hard coat layer in order to improve the abrasion resistance and scratch resistance of the above-mentioned substrate material. On top of this, because the silica-based coating film is very high-grade, not having impurities such as hydrocarbon groups contained in its chemical structure, it is excellent in terms of hardness and transparency.

Furthermore, in a manufacturing method for the silica-based coating film according to the first aspect of the present invention because, after the solution for forming a silica-based coating film is applied to the substrate material and a siloxane compound coating layer is formed, the siloxane compound coating layer reacts with water to form a silica-based coating film, the addition of a catalyst and heat treatment steps which have been carried out in prior art methods such as the sol-gel method are not necessary, and a silica-based coating layer can be formed very simply.

With a solution for forming a silica-based coating film according to the second aspect of the present invention, by including a compound in which a silane compound having activating groups is bonded to anhydrous silica fine particles in the solution for forming a silica-based coating film, the solution can be used without carrying out heat treatment or adding a catalyst as has been done in prior art methods such as the sol-gel method, and a solution for forming a silica-based coating film that is excellent in terms of reactivity with a substrate material and film coatability, which enables the controlling of viscosity, can be provided.

In addition, in a manufacturing method for the solution for forming a silica-based coating film according to the second aspect of the present invention, by dispersing anhydrous silica fine particles in at least either a third mixed solution or a fourth mixed solution and then by mixing, in a dry atmosphere, the third mixed solution, in which silane compound having activating groups has been dissolved in a dry atmosphere, and the fourth mixed solution, in which water has been dissolved, a solution for forming a silica-based coating film, which contains a compound in which a silane compound having activating groups is bonded to anhydrous silica fine particles, is prepared. By adjusting the amount of the anhydrous silica fine particles added accordingly, a solution for forming a silica-based coating film that is excellent in terms of reactivity with a substrate material and film coatability can be prepared with the viscosity being controlled.

Moreover, because a silica-based coating film according to the second aspect of the present invention is such that a silane compound bonds to anhydrous silica fine particles existing in the film and to a substrate material by siloxane bonds, and because the film has a network structure of cross-linking bonds formed by siloxane bonds, the film can be used as a hard coat layer in order to improve the abrasion resistance and scratch resistance of the above-mentioned substrate material. On top of this, because the silica-based coating film is very high-grade, not having impurities such as hydrocarbon groups contained in its chemical structure, it is excellent in terms of hardness and transparency.

Furthermore, in a manufacturing method for the silica-based coating film according to the second aspect of the present invention, after the solution for forming a silica-based coating film is applied to the substrate material in a dry atmosphere and dried to form a siloxane compound coating layer having activating groups, a silica-based coating film having anhydrous silica fine particles on its surface is formed by putting the siloxane compound coating film in contact with water molecules, and the addition of a catalyst and heat treatment steps, which have been carried out in prior art methods such as the sol-gel method are not necessary. Thus, a thick silica-based coating film can be formed very simply. As has been shown, the invention is greatly beneficial to industry.

## Claims

1. A solution for forming a silica-based coating film composing:
an organic solvent; and
a siloxane compound having activating groups.

2. A solution for forming a silica-based coating film according to claim 1, wherein the siloxane compound having activating groups is a compound represented by the general formula (I): 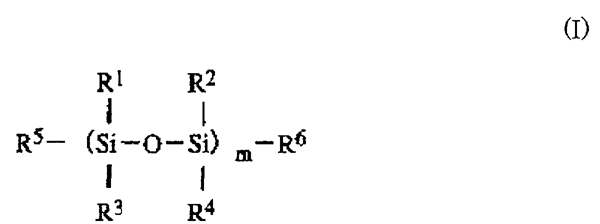 wherein R¹ to R⁴, independently of one another, are a hydrogen atom, a halogen, an isocyanate group, a hydroxyl group, a chlorosilyl group, a dichlorosilyl group, a trichlorosilyl group, a silanol group, or a silicon-containing functional group in which cross-linking can be obtained by forming siloxane bonds; R⁵ and R⁶, independently of one another, are a hydrogen atom, a halogen, an isocyanate group, or a hydroxyl group; and m is an integer of 1 or greater.

3. A solution for forming a silica-based coating film according to claim 2, wherein the siloxane compound having activating groups is a chlorosiloxane.

4. A solution for forming a silica-based coating film according to claim 3, wherein the chlorosiloxane is a chlorosiloxane oligomer.

5. A solution for forming a silica-based coating film according to claim 4, wherein the chlorosiloxane oligomer is at least one compound selected from the group consisting of compounds represented by the general formula (II), the general formula (III), and the general formula (IV): 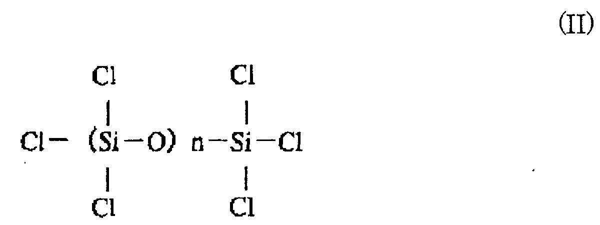 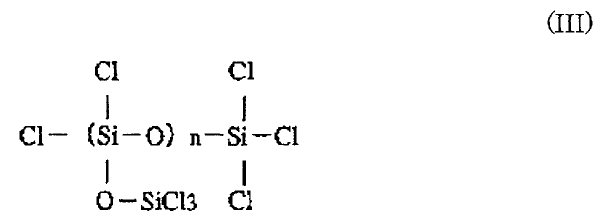 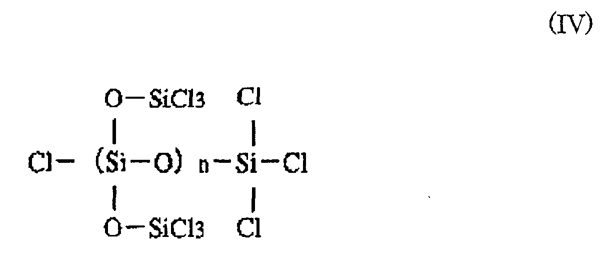 wherein n is an integer of 1 or greater.

6. A solution for forming a silica-based coating film according to claim 1, wherein the organic solvent is a nonaqueous organic solvent.

7. A solution for forming a silica-based coating film according to claim 6, wherein the nonaqueous organic solvent is at least one organic solvent selected from the group consisting of a hydrocarbon-based organic solvent, a fluorine-based organic solvent, and a chlorine-based organic solvent.

8. A solution for forming a silica-based coating film according to claim 5, further comprising an alkoxysilane compound.

9. A solution for forming a silica-based coating film according to claim 8, wherein the alkoxysilane compound is at least one compound selected from the group consisting of tetraethoxysilane and propyloxysilane.

10. A method of manufacturing a solution for forming a silica-based coating film comprising the steps of:
dissolving a silane compound having activating groups in a first organic solvent in a dry atmosphere whereby a first mixed solution is prepared;
mixing an oligomerizer, for oligomerizing the silane compound having activating groups, in a second organic solvent whereby a second mixed solution is prepared; and
mixing the first mixed solution and the second mixed solution in a dry atmosphere.

11. A method of manufacturing a solution for forming a silica-based coating film according to claim 10, wherein the mole ratio of the oligomerizer to the silane compound having activating groups is equimolar or less.

12. A method of manufacturing a solution for forming a silica-based coating film according to claim 11, wherein the oligomerizer is water.

13. A method of manufacturing a solution for forming a silica-based coating film according to claim 10, wherein the silane compound having activating groups is at least one compound selected from the group consisting of tetrachlorosilane, trichlorosilane, dichlorosilane, hexachlorodisiloxane, and octachlorotrisiloxane.

14. A method of manufacturing a solution for forming a silica-based coating film according to claim 10, wherein each of the first organic solvent and the second organic solvent comprises at least one organic solvent selected from the group consisting of a hydrocarbon-based organic solvent, a fluorine-based organic solvent, and a chlorine-based organic solvent.

15. A silica-based coating film wherein:
the silica-based coating film is formed on a surface of a substrate material by siloxane bonds; and
the chemical structure of the silica-based coating film does not contain hydrocarbon groups.

16. A silica-based coating film according to claim 15, comprising a repeating unit represented by the structural formula (V):

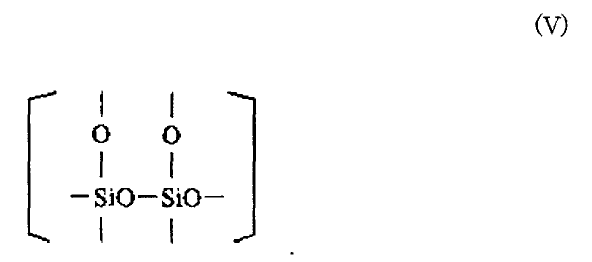

17. A silica-based coating film according to claim 16, wherein:
the substrate material has functional groups having active hydrogens on its surface; and
the heat resistance of the substrate material is 150°C or less.

18. A method of manufacturing a silica-based coating film comprising the steps of:
an applying step of applying a solution for forming a silica-based coating film, the solution comprising an organic solvent and a siloxane compound having activating groups, to a surface of a substrate material in a dry atmosphere;
a drying step of evaporating the organic solvent whereby a siloxane compound coating film having activating groups is formed; and
a silica-based coating film forming step of putting the siloxane compound coating layer in contact with molecules of water whereby a silica-based coating film is formed on the surface of the substrate material.

19. A method of manufacturing a silica-based coating film according to claim 18, wherein the silica-based coating film forming step is carried out in an atmosphere containing moisture.

20. A method of manufacturing a silica-based coating film according to claim 19, further comprising a heat treatment step of heating the silica-based coating film at a temperature of 100°C or higher after the silica-based coating film forming step.

21. A solution for forming a silica-based coating film comprising:
a nonaqueous organic solvent; and
a compound wherein a silane compound having activating groups is bonded to anhydrous silica fine particles.

22. A solution for forming a silica-based coating film according to claim 21, comprising titanium oxide fine particles in place of the anhydrous silica fine particles.

23. A solution for forming a silica-based coating film according to claim 21, wherein the silane compound having activating groups is a compound represented by the general formula (VI): 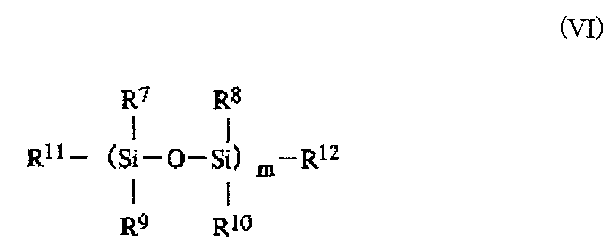 wherein R⁷ to R¹⁰, independently of one another, are a hydrogen atom, a halogen, an isocyanate group, a hydroxyl group, a functional group containing a chlorosilyl group, a functional group containing a dichlorosilyl group, a functional group containing a trichlorosilyl group, a functional group containing a silanol group, or a silicon-containing functional group in which cross-linking can be obtained by forming siloxane bonds; R₁₁ and R₁₂, independently of one another, are a hydrogen atom, a halogen, an isocyanate group, or a hydroxyl group; and m is an integer of 1 or greater.

24. A solution for forming a silica-based coating film according to claim 21, wherein the silane compound having activating groups is a chlorosilane compound.

25. A solution for forming a silica-based coating film according to claim 23, wherein the compound represented by the general formula (VI) is at least one compound selected from the group consisting of compounds represented by the general formula (VII), the general formula (VIII), and the general formula (IX): 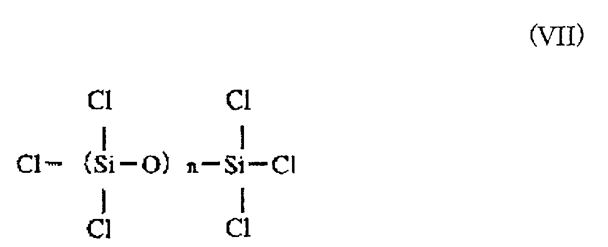 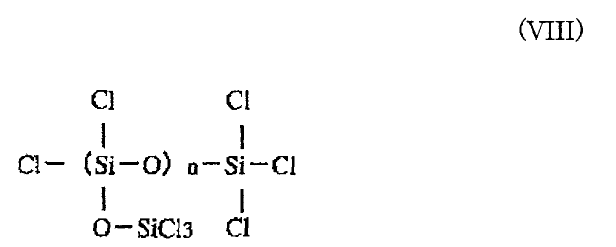 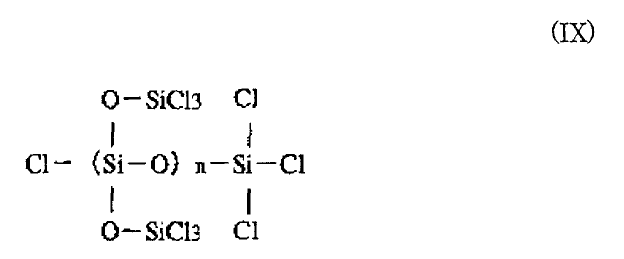 wherein n is an integer of 1 or greater.

26. A solution for forming a silica-based coating film according to claim 21, wherein the nonaqueous organic solvent is at least one organic solvent selected from the group consisting of a hydrocarbon-based organic solvent, a fluorine-based organic solvent, and a chlorine-based organic solvent.

27. A solution for forming a silica-based coating film according to claim 21, further comprising an alkoxysilane compound.

28. A solution for forming a silica-based coating film according to claim 27, wherein the alkoxysilane compound is at least one compound selected from the group consisting of tetraethoxysilane and propyloxysilane.

29. A method of manufacturing a solution for forming a silica-based coating film comprising the steps of:
dissolving a silane compound having activating groups in a first nonaqueous organic solvent in a dry atmosphere whereby the third mixed solution is prepared;
mixing water in a second nonaqueous organic solvent whereby the fourth mixed solution is prepared; and
mixing the third mixed solution and the fourth mixed solution in a dry atmosphere so that the silane compound having activating groups reacts with the water;
the method of manufacturing wherein anhydrous silica fine particles are dispersed in at least one of the third mixed solution and the fourth mixed solution.

30. A method of manufacturing a solution for forming a silica-based coating film according to claim 29, wherein titanium oxide fine particles are used in place of anhydrous silica fine particles.

31. A method of manufacturing a solution for forming a silica-based coating film according to claim 29, wherein the mole ratio of the water to the silane compound having activating groups is equimolar or less.

32. A method of manufacturing a solution for forming a silica-based coating film according to claim 29, wherein the silane compound having activating groups is a chlorosilane compound.

33. A method of manufacturing a solution for forming a silica-based coating film according to claim 32, wherein the chlorosilane compound is at least one compound selected from the group consisting of tetrachlorosilane, trichlorosilane, dichlorosilane, hexachlorodisiloxane, and octachlorotrisiloxane.

34. A method of manufacturing a solution for forming a silica-based coating film according to claim 29, wherein each of the first nonaqueous organic solvent and the second nonaqueous organic solvent comprises at least one organic solvent selected from the group consisting of a hydrocarbon-based organic solvent, a fluorine-based organic solvent, and a chlorine-based organic solvent.

35. A silica-based coating film wherein:
the silica-based coating film is formed on a surface of a substrate material by siloxane bonds;
the silica-based coating film contains anhydrous silica fine particles, the anhydrous silica fine particles being bonded to the silica-based coating film and the substrate material by siloxane bonds; and
the chemical structure of the silica-based coating film does not contain hydrocarbon groups.

36. A silica-based coating film according to claim 35, comprising a repeating unit represented by the structural formula (V):

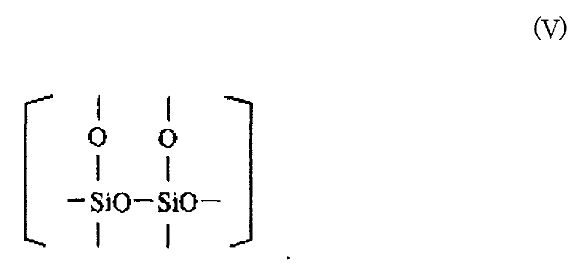

37. A silica-based coating film according to claim 35, comprising titanium oxide fine particles in place of the anhydrous silica fine particles.

38. A silica-based coating film according to claim 37, wherein:
the substrate material has functional groups having activating groups on its surface; and
the heat resistance of the substrate material is 150°C or less.

39. A silica-based coating film according to claim 37, comprising a repeating unit represented by the structural formula (V):

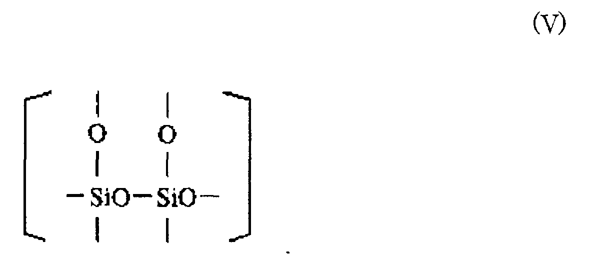

40. A silica-based coating film according to claim 39 wherein:
the substrate material has functional groups having activating groups on its surface; and
the heat resistance of the substrate material is 150°C or less.

41. A method of manufacturing a silica-based coating film comprising the steps of:
an applying step of applying a solution for forming a silica-based coating film to a surface of a substrate material in a dry atmosphere, the solution comprising, a nonaqueous organic solvent and a compound wherein a silane compound having activating groups is bonded to anhydrous silica fine particles,;
a drying step of evaporating the nonaqueous organic solvent whereby a siloxane compound coating film is formed; and
a silica-based coating film forming step of putting the siloxane compound coating layer in contact with molecules of water whereby a silica-based coating film containing the anhydrous silica fine particles is formed on the surface of the substrate material.

42. A method of manufacturing a silica-based coating film according to claim 41, wherein the silica-based coating film forming step is carried out in an atmosphere containing moisture.

43. A method of manufacturing a silica-based coating film according to claim 41, further comprising a heat treatment step of heating the silica-based coating film at a temperature of 100°C or higher after the silica-based coating film forming step.

44. A bonding method by means of a solution for forming a silica-based coating film comprising the steps of:
an applying step of applying the solution for forming a silica-based coating film, the solution comprising an organic solvent and a siloxane compound having activating groups, to a surface of an object in a dry atmosphere;
a bonding step of bonding the object to another object with the solution for forming a silica-based coating film which was applied to the surface of the object;
a drying step of evaporating the nonaqueous organic solvent whereby a siloxane compound coating film having activating groups is formed;
a silica-based coating film forming step of putting the siloxane compound coating film in contact with molecules of water whereby a silica-based coating film is formed on the surface of the substrate material.

45. A bonded structure wherein:
a silica-based coating film is formed on a surface of a substrate material by siloxane bonds; and
an object is bonded to another object with the silica-based coating film, wherein the chemical structure of the silica-based coating film does not contain hydrocarbon groups, disposed therebetween.

46. A paint composition comprising a solution for forming a silica-based coating film comprising:
an organic solvent; and
a siloxane compound having activating groups.

47. A paint composition according to claim 46, comprising one member selected from the group consisting of a colorant, a dyestuff, and a pigment.

48. A passivation film for use in a semiconductor device comprising a silica-based coating film wherein the silica-based coating film is formed on a surface of a substrate material by siloxane bonds, and the chemical structure of the silica-based coating film does not contain hydrocarbon groups.

49. A passivation film for use in a thin film transistor array comprising a silica-based coating film wherein the silica-based coating film is formed on a surface of a substrate material by siloxane bonds, and the chemical structure of the silica-based coating film does not contain hydrocarbon groups.

## Amended claims

### Amended claims under Art. 19.1 PCT

**1.** (Amended) A solution for forming a silica-based coating film comprising:
a nonaqueous organic solvent; and
a siloxane compound having activating groups.

**2.** (Amended) A solution for forming a silica-based coating film according to claim 1, wherein the siloxane compound does not have hydrocarbon groups.

**3.** (Amended) A solution for forming a silica-based coating film according to claim 1, wherein the siloxane compound is a compound represented by the general formula (I): 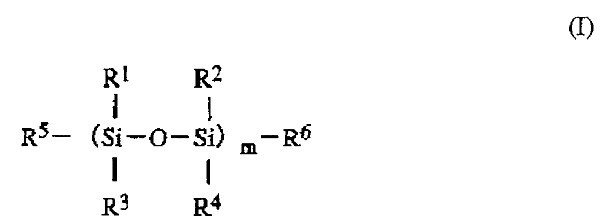 wherein R¹ to R⁴, independently of one another, are a hydrogen atom, a halogen, an isocyanate group, a hydroxyl group, a chlorosilyl group, a dichlorosilyl group, a trichlorosilyl group, a silanol group, or a silicon-containing functional group in which cross-linking can be obtained by forming siloxane bonds; R⁵ and R⁶, independently of one another, are a hydrogen atom, a halogen, an isocyanate group, or a hydroxyl group; at least one of R¹ to R⁴ represents an activating group and/or at least one of R⁵ and R⁶ represents a chlorine atom or an isocyanate group; and m is an integer of 1 or greater.

**4.** (Amended) A solution for forming a silica-based coating film according to claim 3, wherein the siloxane compound is a chlorosiloxane.

**5.** (Amended) A solution for forming a silica-based coating film according to claim 4, wherein the chlorosiloxane is a chlorosiloxane oligomer.

**6.** (Amended) A solution for forming a silica-based coating film according to claim 5, wherein the chlorosiloxane oligomer is at least one compound selected from the group consisting of compounds represented by the general formula (II), the general formula (III), and the general formula (IV): 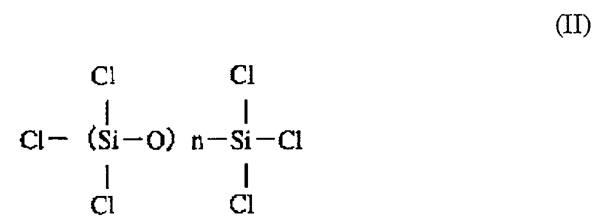 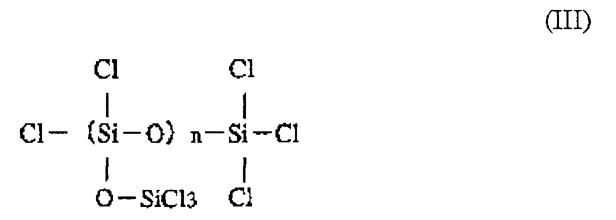 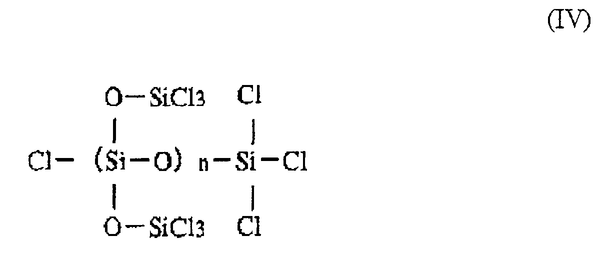 wherein n is an integer of 1 or greater.

**7.** (Amended) A solution for forming a silica-based coating film according to claim 1, wherein the nonaqueous organic solvent is at least one organic solvent selected from the group consisting of a hydrocarbon-based organic solvent, a fluorine-based organic solvent, and a chlorine-based organic solvent.

**8.** (Amended) A solution for forming a silica-based coating film according to claim 6, further comprising an alkoxysilane compound.

**9.** A solution for forming a silica-based coating film according to claim 8, wherein the alkoxysilane compound is at least one compound selected from the group consisting of tetraethoxysilane and propyloxysilane.

**10.** A method of manufacturing a solution for forming a silica-based coating film comprising the steps of:
dissolving a silane compound having activating groups in a first organic solvent in a dry atmosphere whereby a first mixed solution is prepared;
mixing an oligomerizer, for oligomerizing the silane compound having activating groups, in a second organic solvent whereby a second mixed solution is prepared; and
mixing the first mixed solution and the second mixed solution in a dry atmosphere.

**11.** A method of manufacturing a solution for forming a silica-based coating film according to claim 10, wherein the mole ratio of the oligomerizer to the silane compound having activating groups is equimolar or less.

**12.** A method of manufacturing a solution for forming a silica-based coating film according to claim 11, wherein the oligomerizer is water.

**13.** A method of manufacturing a solution for forming a silica-based coating film according to claim 10, wherein the silane compound having activating groups is at least one compound selected from the group consisting of tetrachlorosilane, trichlorosilane, dichlorosilane, hexachlorodisiloxane, and octachlorotrisiloxane.

**14.** A method of manufacturing a solution for forming a silica-based coating film according to claim 10, wherein each of the first organic solvent and the second organic solvent comprises at least one organic solvent selected from the group consisting of a hydrocarbon-based organic solvent, a fluorine-based organic solvent, and a chlorine-based organic solvent.

**15.** A silica-based coating film wherein:
the silica-based coating film is formed on a surface of a substrate material by siloxane bonds; and
the chemical structure of the silica-based coating film does not contain hydrocarbon groups.

**16.** A silica-based coating film according to claim 15, comprising a repeating unit represented by the structural formula (V):

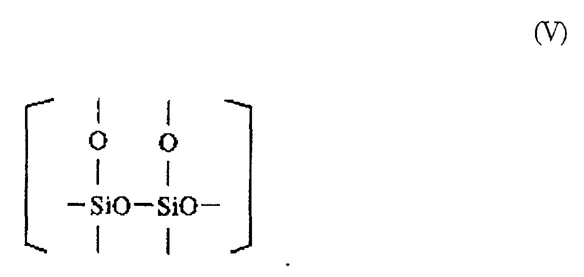

**17.** A silica-based coating film according to claim 16, wherein:
the substrate material has functional groups having active hydrogens on its surface; and
the heat resistance of the substrate material is 150°C or less.

**18.** A method of manufacturing a silica-based coating film comprising the steps of:
an applying step of applying a solution for forming a silica-based coating film, the solution comprising an organic solvent and a siloxane compound having activating groups, to a surface of a substrate material in a dry atmosphere;
a drying step of evaporating the organic solvent whereby a siloxane compound coating film having activating groups is formed; and
a silica-based coating film forming step of putting the siloxane compound coating layer in contact with molecules of water whereby a silica-based coating film is formed on the surface of the substrate material.

**19.** A method of manufacturing a silica-based coating film according to claim 18, wherein the silica-based coating film forming step is carried out in an atmosphere containing moisture.

**20.** A method of manufacturing a silica-based coating film according to claim 19, further comprising a heat treatment step of heating the silica-based coating film at a temperature of 100°C or higher after the silica-based coating film forming step.

**21.** A solution for forming a silica-based coating film comprising:
a nonaqueous organic solvent; and
a compound wherein a silane compound having activating groups is bonded to anhydrous silica fine particles.

**22.** (Amended) A solution for forming a silica-based coating film according to claim 21, wherein the compound does not have hydrocarbon groups.

**23.** (Amended) A solution for forming a silica-based coating film according to claim 21, comprising titanium oxide fine particles in place of the anhydrous silica fine particles.

**24.** (Amended) A solution for forming a silica-based coating film according to claim 21, wherein the silane compound is a compound represented by the general formula (VI): 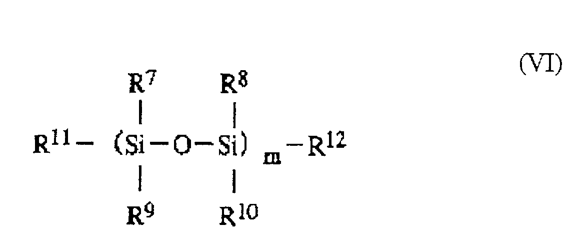 wherein R⁷ to R¹⁰, independently of one another, are a hydrogen atom, a halogen, an isocyanate group, a hydroxyl group, a chlorosilyl group, a dichlorosilyl group, a trichlorosilyl group, a silanol group, or a silicon-containing functional group in which cross-linking can be obtained by forming siloxane bonds; R¹¹ and R¹², independently of one another, are a hydrogen atom, a halogen, an isocyanate group, or a hydroxyl group; at least one of R⁷ to R¹⁰ represents an activating group and/or at least one of R¹¹ and R¹² represents a chlorine atom or an isocyanate group; and m is an integer of 1 or greater.

**25.** (Amended) A solution for forming a silica-based coating film according to claim 21, wherein the silane compound is a chlorosilane compound.

**26.** (Amended) A solution for forming a silica-based coating film according to claim 24, wherein the compound represented by the general formula (VI) is at least one compound selected from the group consisting of compounds represented by the general formula (VII), the general formula (VIII), and the general formula (IX): 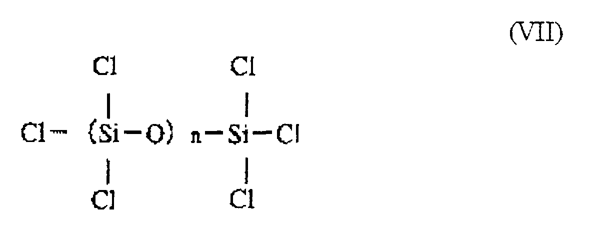 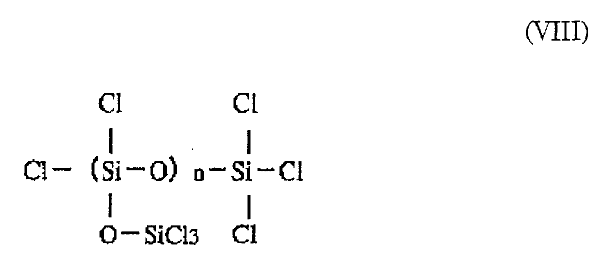 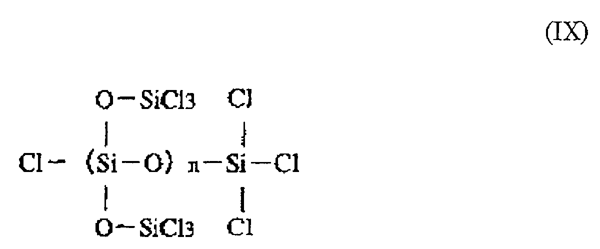 wherein n is an integer of 1 or greater.

**27.** (Amended) A solution for forming a silica-based coating film according to claim 21, wherein the nonaqueous organic solvent is at least one organic solvent selected from the group consisting of a hydrocarbon-based organic solvent, a fluorine-based organic solvent, and a chlorine-based organic solvent.

**28.** (Amended) A solution for forming a silica-based coating film according to claim 21, further comprising an alkoxysilane compound.

**29.** (Amended) A solution for forming a silica-based coating film according to claim 28, wherein the alkoxysilane compound is at least one compound selected from the group consisting of tetraethoxysilane and propyloxysilane.

**30.** (Amended) A method of manufacturing a solution for forming a silica-based coating film comprising the steps of:
dissolving a silane compound having activating groups in a first nonaqueous organic solvent in a dry atmosphere whereby the third mixed solution is prepared;
mixing water in a second nonaqueous organic solvent whereby the fourth mixed solution is prepared; and
mixing the third mixed solution and the fourth mixed solution in a dry atmosphere so that the silane compound having activating groups reacts with the water;
the method of manufacturing wherein anhydrous silica fine particles are dispersed in at least one of the third mixed solution and the fourth mixed solution.

**31.** (Amended) A method of manufacturing a solution for forming a silica-based coating film according to claim 30, wherein titanium oxide fine particles are used in place of anhydrous silica fine particles.

**32.** (Amended) A method of manufacturing a solution for forming a silica-based coating film according to claim 30, wherein the mole ratio of the water to the silane compound having activating groups is equimolar or less.

**33.** (Amended) A method of manufacturing a solution for forming a silica-based coating film according to claim 30, wherein the silane compound having activating groups is a chlorosilane compound.

**34.** (Amended) A method of manufacturing a solution for forming a silica-based coating film according to claim 33, wherein the chlorosilane compound is at least one compound selected from the group consisting of tetrachlorosilane, trichlorosilane, dichlorosilane, hexachlorodisiloxane, and octachlorotrisiloxane.

**35.** (Amended) A method of manufacturing a solution for forming a silica-based coating film according to claim 30, wherein each of the first nonaqueous organic solvent and the second nonaqueous organic solvent comprises at least one organic solvent selected from the group consisting of a hydrocarbon-based organic solvent, a fluorine-based organic solvent, and a chlorine-based organic solvent.

**36.** (Amended) A silica-based coating film wherein:
the silica-based coating film is formed on a surface of a substrate material by siloxane bonds;
the silica-based coating film contains anhydrous silica fine particles, the anhydrous silica fine particles being bonded to the silica-based coating film and the substrate material by siloxane bonds; and
the chemical structure of the silica-based coating film does not contain hydrocarbon groups.

**37.** (Amended) A silica-based coating film according to claim 36, comprising a repeating unit represented by the structural formula (V):

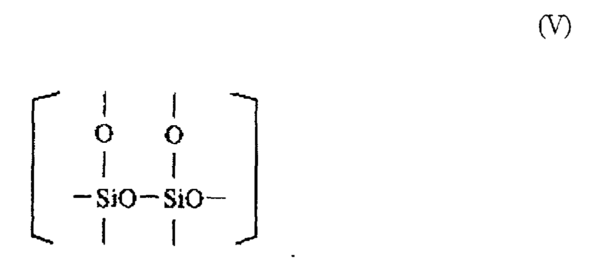

**38.** (Amended) A silica-based coating film according to claim 36, comprising titanium oxide fine particles in place of the anhydrous silica fine particles.

**39.** (Amended) A silica-based coating film according to claim 38, wherein:
the substrate material has functional groups having activating groups on its surface; and
the heat resistance of the substrate material is 150°C or less.

**40.** (Amended) A silica-based coating film according to claim 38, comprising a repeating unit represented by the structural formula (V):

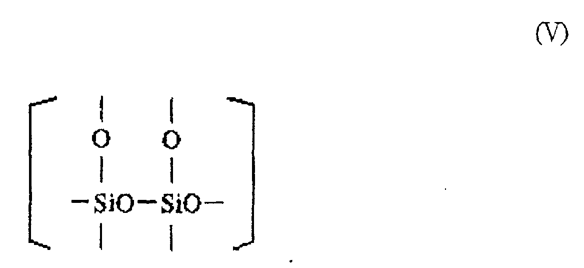

**41.** (Amended) A silica-based coating film according to claim 40 wherein:
the substrate material has functional groups having activating groups on its surface; and
the heat resistance of the substrate material is 150°C or less.

**42.** (Amended) A method of manufacturing a silica-based coating film comprising the steps of:
an applying step of applying a solution for forming a silica-based coating film to a surface of a substrate material in a dry atmosphere, the solution comprising, a nonaqueous organic solvent and a compound wherein a silane compound having activating groups is bonded to anhydrous silica fine particles,;
a drying step of evaporating the nonaqueous organic solvent whereby a siloxane compound coating film is formed; and
a silica-based coating film forming step of putting the siloxane compound coating layer in contact with molecules of water whereby a silica-based coating film containing the anhydrous silica fine particles is formed on the surface of the substrate material.

**43.** (Amended) A method of manufacturing a silica-based coating film according to claim 42, wherein the silica-based coating film forming step is carried out in an atmosphere containing moisture.

**44.** (Amended) A method of manufacturing a silica-based coating film according to claim 42, further comprising a heat treatment step of heating the silica-based coating film at a temperature of 100°C or higher after the silica-based coating film forming step.

**45.** (Amended) A bonding method by means of a solution for forming a silica-based coating film comprising the steps of:
an applying step of applying the solution for forming a silica-based coating film, the solution comprising an organic solvent and a siloxane compound having activating groups, to a surface of an object in a dry atmosphere;
a bonding step of bonding the object to another object with the solution for forming a silica-based coating film which was applied to the surface of the object;
a drying step of evaporating the nonaqueous organic solvent whereby a siloxane compound coating film having activating groups is formed;
a silica-based coating film forming step of putting the siloxane compound coating film in contact with molecules of water whereby a silica-based coating film is formed on the surface of the substrate material.

**46.** (Amended) A bonded structure wherein:
a silica-based coating film is formed on a surface of a substrate material by siloxane bonds; and
an object is bonded to another object with the silica-based coating film, wherein the chemical structure of the silica-based coating film does not contain hydrocarbon groups, disposed therebetween.

**47.** (Amended) A paint composition comprising a solution for forming a silica-based coating film comprising:
a nonaqueous organic solvent; and
a siloxane compound having activating groups.

**48.** (Amended) A solution for forming a silica-based coating film according to claim 47, wherein the siloxane compound does not have hydrocarbon groups.

**49.** (Amended) A paint composition according to claim 47, comprising one member selected from the group consisting of a colorant, a dyestuff, and a pigment.

**50.** (Amended) A passivation film for use in a semiconductor device comprising a silica-based coating film wherein the silica-based coating film is formed on a surface of a substrate material by siloxane bonds, and the chemical structure of the silica-based coating film does not contain hydrocarbon groups.

**51.** (Amended) A passivation film for use in a thin film transistor array comprising a silica-based coating film wherein the silica-based coating film is formed on a surface of a substrate material by siloxane bonds, and the chemical structure of the silica-based coating film does not contain hydrocarbon groups.

Statement under Art. 19.1 PCT
Claims 1 to 8 relate to a solution for forming a silica-based coating film comprising a nonaqueous organic solvent and a siloxane compound having activating groups.

Claims 22 to 29 relate to a solution for forming a silica-based coating film comprising a nonaqueous organic solvent and a compound wherein a silane compound having activating groups is bonded to anhydrous silica fine particles. In addition, claims 30 to 35 relate to a method of manufacturing this solution for forming a silica-based coating film

Claims 36 to 41 relate to a silica-based coating film containing anhydrous silica fine particles and not containing hydrocarbon groups in its chemical structure. In addition, claims 41 to 44 relate to a method of manufacturing this silica-based coating film.

Claim 45 relates to a bonding method using a solution for forming a silica-based coating film comprising an organic solvent and a siloxane compound having activating groups. Claim 46 relates to a bonded structure wherein an object is bonded to another object with a silica-based coating film.

Claims 47 and 48 relate to a paint composition comprising a solution for forming a silica-based coating film which comprises an organic solvent and a siloxane compound having activating groups.

Claim 49 relates to a passivation film for use in a semiconductor device comprising a silica-based coating film wherein the silica-based coating film is formed on a surface of a substrate material by siloxane bonds, and the chemical structure of the silica-based film does not contain hydrocarbon groups. Claim 50 relates to a passivation film for use in a thin film transistor array comprising the above-mentioned silica-based coating film.
